# EUROPEAN PATENT SPECIFICATION

(11) **EP 4 629 661 B1**
(45) Date of publication and mention of the grant of the patent: **21.10.2026**
(21) Application number: 25187733.8
(22) Date of filing: 08.08.2023
(51) Int. Cl.: H04R 9/06, H04R 25/00, G06F 1/16, G02C 11/00, G02B 27/01, H04R 1/10, H04R 1/02, H04R 1/06, H04R 1/08, H04R 1/1025, H04R 1/24, H04R 1/32, H04R 1/46, H04R 1/26, H04R 3/00, H04R 3/12, H04R 5/033, H04R 7/12, H04R 9/02, H04R 11/02

(54) **EARPHONE**
KOPFHÖRER
ÉCOUTEUR

(30) Priority: 12.05.2023 CN 202310541798
(43) Date of publication of application: 08.10.2025
(62) Document number(s) of the earlier application(s) in accordance with Art. 76 EPC: 23937159.4 / 4 626 019
(73) Proprietor: Shenzhen Shokz Co., Ltd., Shenzhen, Guangdong 518108 (CN)
(72) Inventor: XIE, Shuailin, Shenzhen, 518108 (CN); LIU, Chunjian, Shenzhen, 518108 (CN); GUO, Burui, Shenzhen, 518108 (CN); LI, Yongjian, Shenzhen, 518108 (CN)
(74) Representative: Wang, Bo

(56) References cited:
- CN-U- 214 544 718
- US-A1- 2022 030 348

## Description

### CROSS-REFERENCE TO RELATED APPLICATION

This application claims priority of Chinese Patent Application No. 202310541798.X, filed on May 12, 2023.

### TECHNICAL FIELD

The present disclosure relates to the technical field of electronic devices, and in particular to headphones.

### BACKGROUND

With the continuous popularization of electronic devices, electronic devices have become indispensable tools for socializing and entertainment in people's daily lives, and people's requirements for electronic devices are getting higher and higher. The electronic devices such as headphones have also been widely used in people's daily lives. The headphones can be used com in conjunction with cell phones, computers, and other terminal devices to provide users with a feast of hearing. However, the wires of the headphones are poorly sealed and fixed when they extend from the corresponding components. CN214544718 U discloses a waterproof structure for earphone keys.

### SUMMARY

The present disclosure provides a headphone including a housing assembly. The housing assembly includes a first housing and a second housing, the first housing being provided with an accommodation cavity with at least one open end; the headphone includes a key assembly at least partially inserted into the accommodation cavity through the open end, the key assembly cooperating with the first housing to form a glue slot visible from the outside of the first housing through the open end; and the second housing is arranged on the open end of the first housing and covers the glue slot.

In some embodiments, the key assembly includes a key support with an annular bump disposed on an outer wall surface, an annular support platform is disposed on an inner wall surface of the first housing, the annular bump is supported on the annular support platform, and the annular bump sinks for a specific distance with respect to the open end, and on a side of the annular bump facing the open end, the outer wall surface of the key support and the inner wall surface of the first housing cooperate with each other to form the glue slot.

In some embodiments, an outer end surface of the key support that is away from the accommodation cavity protrudes from the open end, the key assembly includes an elastic pressing member provided on the outer end surface, the second housing is provided with a keyhole, and the elastic pressing member is exposed through the keyhole.

In some embodiments, in an insert direction of the key assembly relative to the accommodation cavity, the first housing includes a first wall portion and a second wall portion connected to each other, the second wall portion being disposed on a side of the first wall portion away from the open end, the annular support platform is disposed at a connection between the first wall portion and the second wall portion, and the key support includes an insert portion disposed on a side of the annular bump away from the open end, the insert portion being inserted into the second wall portion.

In some embodiments, the housing assembly further includes an elastic covering layer covered on an outer surface of the first housing, on a side where the open end is located, the first housing has an exposed portion that is not covered by the elastic covering layer, and the exposed portion is inserted into the second housing, and the second housing abuts against the elastic covering layer in an insertion direction of the exposed portion relative to the second housing.

In some embodiments, the exposed portion cooperates with the second housing to form a glue gap for connecting the glue slot.

In some embodiments, a depth of at least a portion of the glue slot is greater than or equal to 0.2 mm in an insert direction of the key assembly relative to the accommodation cavity.

In some embodiments, a width of at least a portion of the glue slot is greater than or equal to 0.4 mm in a vertical direction of the insert direction of the key assembly relative to the accommodation cavity.

In some embodiments, the first housing is further provided with a receiving slot in flow communication with the accommodation cavity, the headphone further includes an interface assembly inserted into the receiving slot, and the second housing is configured to partially cover the interface assembly.

In some embodiments, the headphone further comprises a dustproof plug, the dustproof plug includes a plug body and a fixing portion, the fixing portion is disposed on the first housing between the key assembly and the interface assembly through the second housing, and the plug body is connected to the fixing portion and configured to selectively cover the interface assembly.

### BRIEF DESCRIPTION OF THE DRAWINGS

To more clearly illustrate the technical solutions in the embodiments of the present disclosure, the following will briefly introduce the accompanying drawings that need to be used in the description of the embodiments, and obviously, the accompanying drawings in the following description are only some of the embodiments of the present disclosure, and other attachments may be obtained according to them without creative labor to those skilled in the art.
FIG. 1 is a schematic diagram illustrating a three-dimensional (3D) structure of an overall assembly of a headphone according to some embodiments of the present disclosure;
FIG. 2 is a schematic diagram illustrating an exploded view of a core assembly shown in FIG. 1;
FIG. 3 is a schematic diagram illustrating a section structure of an ear hook assembly shown in FIG. 1;
FIG. 4 is a schematic diagram illustrating a disassembled structure of an ear hook assembly shown in FIG. 3;
FIG. 5 is a schematic diagram illustrating another section structure of an ear hook assembly shown in FIG. 3;
FIG. 6 is a schematic diagram illustrating an enlarged structure of a J-region of an ear hook assembly shown in FIG. 5;
FIG. 7 is a schematic diagram illustrating a section structure of an ear hook assembly with some parts hidden shown in FIG. 3;
FIG. 8 is a schematic diagram illustrating an enlarged structure of a K region of an ear hook assembly shown in FIG. 7;
FIG. 9 is a schematic diagram illustrating another disassembled structure of an ear hook assembly shown in FIG. 1;
FIG. 10 is a schematic diagram illustrating a section structure of an ear hook assembly shown in FIG. 9;
FIG. 11 is a schematic illustrating an enlarged structure of an R region of an ear hook assembly shown in FIG. 10;
FIG. 12 is a schematic diagram illustrating another section structure of an ear hook assembly with some parts hidden shown in FIG. 9;
FIG. 13 is a schematic diagram illustrating an enlarged structure of a T-region of an ear hook assembly shown in FIG. 12;
FIG. 14 is a schematic diagram illustrating a partial structure of a headphone shown in FIG. 1;
FIG. 15 is a schematic diagram illustrating a disassembled structure of a structure shown in FIG. 14;
FIG. 16 is a schematic diagram illustrating a section structure of a structure shown in FIG. 14 along a P-P section line;
FIG. 17 is a schematic diagram illustrating a section structure of a structure shown in FIG. 14 along an R-R section line;
FIG. 18 is a schematic diagram illustrating another section structure of a structure shown in FIG. 14 along a P-P section line;
FIG. 19 is a schematic diagram illustrating an enlarged structure of a Q region of a structure shown in FIG. 16;
FIG. 20 is a schematic diagram illustrating a partial structure of a wearing assembly shown in FIG. 15;
FIG. 21 is a schematic diagram illustrating a partial structure of a stopper and an insert body shown in FIG. 15;
FIG. 22 is a schematic diagram illustrating another partial structure of a headphone shown in FIG. 1;
FIG. 23 is a schematic diagram illustrating a dissembled structure shown in FIG. 22;
FIG. 24 is a schematic diagram illustrating a section structure of a structure shown in FIG. 22 along an E-E section line;
FIG. 25 is a schematic diagram illustrating an enlarged structure of a Q region shown in FIG. 24;
FIG. 26 is a schematic diagram illustrating a section structure of a structure shown in FIG. 22 along a G-G section line;
FIG. 27 is a schematic diagram illustrating an enlarged structure of an H region of a headphone shown in FIG. 26;
FIG. 28 is a schematic diagram illustrating a partial structure of a headphone shown in FIG. 1;
FIG. 29 is a schematic diagram illustrating a section structure of a structure shown in FIG. 28 along an M-M section line;
FIG. 30 is a schematic diagram illustrating a structure of a housing assembly shown in FIG. 29;
FIG. 31 is a schematic diagram illustrating an enlarged structure of an A1 region shown in FIG. 29;
FIG. 32 is a schematic diagram illustrating a structure of a wearing assembly according to some embodiments of the present disclosure;
FIG. 33 is a schematic diagram illustrating an enlarged structure of an A2 region shown in FIG. 29;
FIG. 34 is a schematic diagram illustrating an exemplary partial structure of a rear hook assembly shown in FIG. 1;
FIG. 35 is a schematic diagram illustrating another view of a rear hook assembly shown in FIG. 34;
FIG. 36 is a schematic diagram illustrating a cross-sectional structure of a rear hook assembly in an insert direction shown in FIG. 34;
FIG. 37 is a schematic diagram illustrating another exemplary partial structure of a rear hook assembly shown in FIG. 1;
FIG. 38 is a schematic diagram illustrating a cross-sectional structure of a wire assembly of a rear hook assembly shown in FIG. 34;
FIG.39 is a schematic diagram illustrating another exemplary partial structure of a rear hook assembly shown in FIG. 1; and
FIG. 40 is a schematic diagram illustrating a structure of an insert member of a rear hook assembly shown in FIG. 39.

### DETAILED DESCRIPTION

The present disclosure is described in further detail below combining the accompanying drawings and embodiments. In particular, it is noted that the following embodiments are only for the purpose of illustration, but do not limit the scope of the present disclosure. The scope of the invention is defined by the appended claims.

References to "embodiments" in the present disclosure mean that particular features, structures, or characteristics described combining embodiments may be included in at least one embodiment of the present disclosure. It is understood by those skilled in the art, both explicitly and implicitly, that the embodiments described in the present disclosure may be combined with other embodiments.

The following embodiments of the present disclosure describe an exemplary structure of a headphone 100.

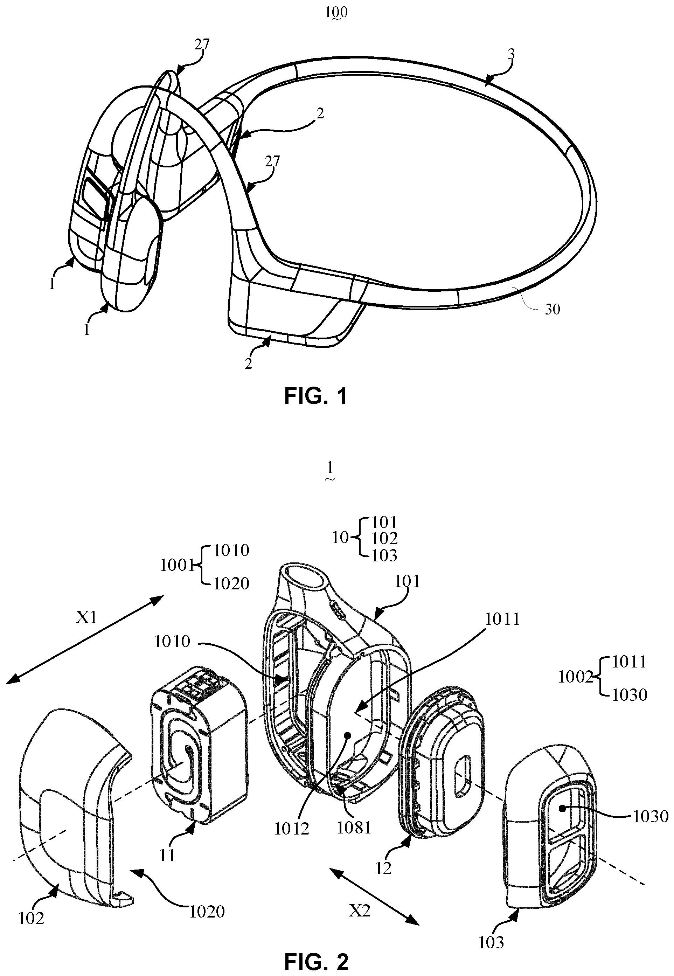

As shown in FIG. 1, the headphone 100 includes a core assembly 1, an ear hook assembly 2, and a rear hook assembly 3. There may be two core assemblies 1. The two core assemblies 1 are configured to transmit a vibration and/or a sound to a left ear and a right ear of a user, respectively. The two core assemblies 1 may be the same or different. For example, one core assembly 1 is provided with a microphone, and the other core assembly 1 is not provided with the microphone. For example, one core assembly 1 is provided with a key and a corresponding circuit board, and the other core assembly 1 is not provided with the key and the corresponding circuit board. The two core assemblies 1 may be the same on a core module (e.g., a speaker module). The following is a detailed description of one of the two core assemblies 1 as an example. There may be two ear hook assemblies 2, and the two ear hook assemblies 2 may be located on the left and the right ears of the user, respectively, so as to enable the core assemblies1 to fit to a surface of the user. For example, one of the ear hook assemblies 2 is provided with a battery, and the other ear hook assembly 2 is provided with a control circuit, etc. One end of each of the ear hook assemblies 2 is connected to a core assembly 1, and the other end of each of the ear hook assemblies 2 is connected to the rear hook assembly 3. The rear hook assembly 3 connects the two ear hook assemblies 2, and the rear hook assembly 3 is configured to wrap around a back of a neck of the user or a back of a head of the user and provide a clamping force that allows the two core assemblies 1 to be clamped to both sides of the user's face, and makes the ear hook assembly 2 to be more securely attached to the ears of the user. In some embodiments, the headphone 100 may not include the rear hook assembly 3, and the core assembly 1 is worn in the ears of the user through the ear hook assembly 2.

The following contents mainly describe an exemplary structure of the core assembly 1 and other structures of the headphone 100.

As shown in FIG. 2, the core assembly 1 may include a housing assembly 10, a bone conduction speaker 11, and an air conduction speaker 12.

The housing assembly 10 may be provided with an accommodation cavity 1001 and an accommodation cavity 1002 isolated from each other. The housing assembly 10 may also be referred to as a core housing assembly 10. The bone conduction speaker 11 is provided in the accommodation cavity 1001.

The air conduction speaker 12 conducts the sound into the ear canal of the user through air vibration, and the bone conduction speaker 11 conducts the sound into the user through the bone conduction vibration. A sealing of the accommodation cavity 1001 is greater than a sealing of the accommodation cavity 1002. The sealing refers to a gas tightness. As the accommodation cavity 1002 where the air conduction speaker 12 is placed needs to be in flow communication with an outside world to facilitate a conduction of sound waves through the air, the bone conduction speaker 11 and the air conduction speaker 12 are disposed independently of each other, and there is no need to dispose the bone conduction speaker 11 in the accommodating cavity 1002. Since the accommodating cavities 1001 is disposed independently, the sealing of the accommodating cavity 1001 may be set higher, which effectively improves the sealing effect of the bone conduction speaker 11 and thereby preventing the bone conduction speaker 11 from being damaged by erosion of external environmental factors, and at the same time ensures a sound quality of the air conduction speaker 12. In addition, the headphone 100 may effectively reduce mutual interference between the bone conduction speaker 11 and the air conduction speaker 12 when the bone conduction speaker 11 and the air conduction speaker 12 are working at the same time, thereby effectively enhancing the sound quality of the headphone 100.

In some embodiments, the housing assembly 10 may include a housing 101, a housing 102, and a housing 103, with the housing 101 and the housing 102 cooperating with each other to form the accommodation cavity 1001. The housing 101 and/or the housing 102 further form a portion of the accommodation cavity 1002, and the housing 103 may form another portion of the accommodation cavity 1002 such that the housing 103 cooperates with the housing 101 and/or the housing 102 to form the accommodation cavity 1002. In some embodiments, at least the cooperation between the housing 101 and the housing 102 forms the accommodation cavity 1001, and at least the cooperation between the housing 103 and the housing 102 forms the accommodation cavity 1002.

In some embodiments, a vibration direction of the bone conduction speaker 11 crosses a vibration direction of the air conduction speaker 12, and the housing 101 and the housing 102 cooperate with each other in the vibration direction of the bone conduction speaker 11. The housing 103 cooperates with the housing 101 and/or the housing 102 in a vibration direction of the air conduction speaker 12.

The vibration direction of the bone conduction speaker 11 may also be referred to herein as a bone conduction vibration direction X1, and the vibration direction of the air conduction speaker 12 may also be referred to herein as an air conduction vibration direction X2. The bone conduction vibration direction X1 and the air conduction vibration direction X2 are not parallel to each other but cross each other. For example, the bone conduction vibration direction X1 and the air conduction vibration direction X2 are perpendicular or approximately perpendicular to each other (e.g., 90° ± 10°). When the bone conduction speaker 11 and the air conduction speaker 12 are working at the same time, the bone conduction speaker 11 and the air conduction speaker 12 are vibrating in the bone conduction vibration direction X1 and the air conduction vibration direction X2, respectively. As the two vibration directions are crosswise, an impact of the vibration of the bone conduction speaker 11 on the sound quality of the air conduction speaker 12 caused by a same-direction vibration of the bone conduction speaker 11 and the air conduction speaker 12 is relieved.

Referring to FIG. 2, in some embodiments, the housing assembly 10 may also be provided with a pressure relief hole 1081 for connecting the accommodation cavity 1002 to the external environment. The pressure relief hole 1081 is disposed to extend toward the accommodation cavity 1001. The housing assembly 10 is disposed with the pressure relief hole 1081 for relieving pressure for the air conduction speaker 12. The pressure relief hole 1081 connects the accommodation cavity 1002 to the external environment, and the pressure relief hole 1081 extends from a connection with the accommodation cavity 1002 toward the accommodation cavity 1001.

The housing assembly 10 may include a partition wall 1012 for isolating the accommodation cavity 1001 and the accommodation cavity 1002, with at least a portion of the partition wall 1012 extending toward the accommodation cavity 1001 and forming a part of a hole wall of the pressure relief hole 1081. The partition wall 1012 is disposed on the housing 101, and the housing 101 is provided with a sub-accommodation cavity 1010 and a sub-accommodation cavity 1011 disposed on opposite sides of the partition wall 1012. An opening direction of the sub-accommodation cavity 1010 is arranged along a wall surface of the partition wall 1012. Specifically, the opening direction of the sub-accommodation cavity 1010 is parallel or substantially parallel to the wall surface of the partition wall 1012. The opening direction of the sub-accommodation cavity 1011 crosses the wall surface of the partition wall 1012. The housing 102 is provided with a sub-accommodation cavity 1020, the housing 102 is covered at an open end of the sub-accommodation cavity 1010, and the sub-accommodation cavity 1020 cooperates with the sub-accommodation cavity 1010 to form the accommodation cavity 1001. The housing 103 is provided with a sub-accommodation cavity 1030. The housing 103 is covered at an open end of the sub-accommodation cavity 1011, and the sub-accommodation cavity 1030 cooperates with the sub-accommodation cavity 1011 to form the accommodation cavity 1002.

The following describes primarily a structure of the ear hook assembly 2, etc. of the headphone 100.

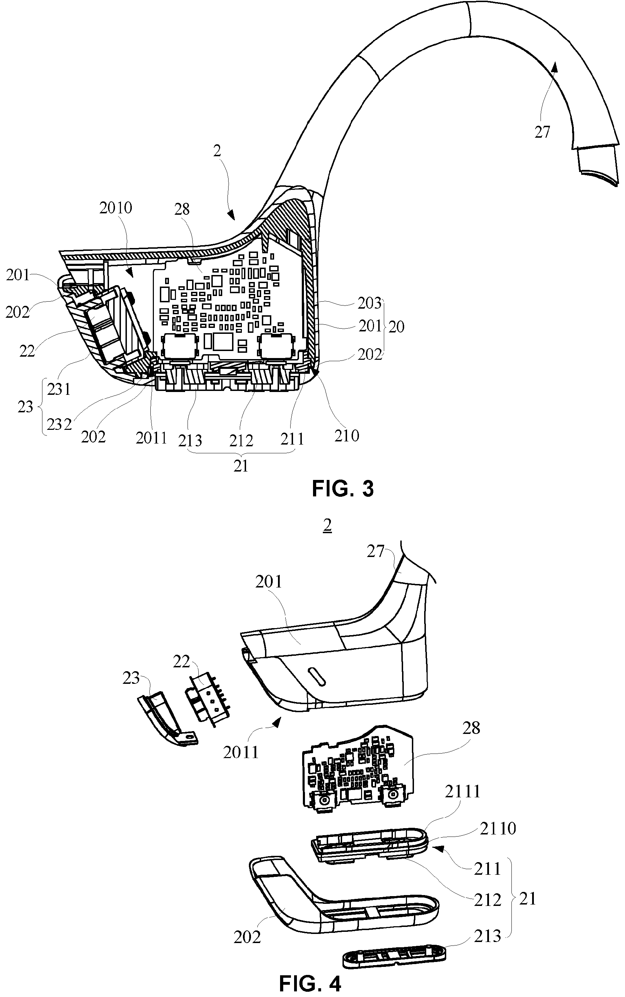

In combination with FIGs. 3-5, the ear hook assembly 2 may include a housing assembly 20 and a key assembly 21. The housing assembly 20 includes a housing 201 and a housing 202. The housing assembly 20 is disposed with an accommodation cavity 2010, and the accommodation cavity 2010 has at least one open end 2011. The key assembly 21 is at least partially inserted into the accommodation cavity 2010 through the open end 2011, and the key assembly 21 cooperates with the housing 201 to form a glue slot 210 that is visible from the outside of the housing 201 through the open end 2011. The housing 202 is arranged on the open end 2011 of the housing 201 and covers the glue slot 210. The open end 2011 refers to an end of the housing 201 provided with an opening.

In some embodiments, a circuit board 28 may be provided within the accommodation cavity 2010. The circuit board 28 is used to perform a conversion process on electrical signals to support the realization of functions of the headphone 100. The key assembly 21 is used to accept a press of the user to move relative to the circuit board 28, thereby triggering the circuit board 28 to operate. For example, the key assembly 21 triggers the circuit board 28 to realize the functions such as switching on/off, switching playback content, increasing/decreasing volume, etc., of the headphone 100 when pressed by the user.

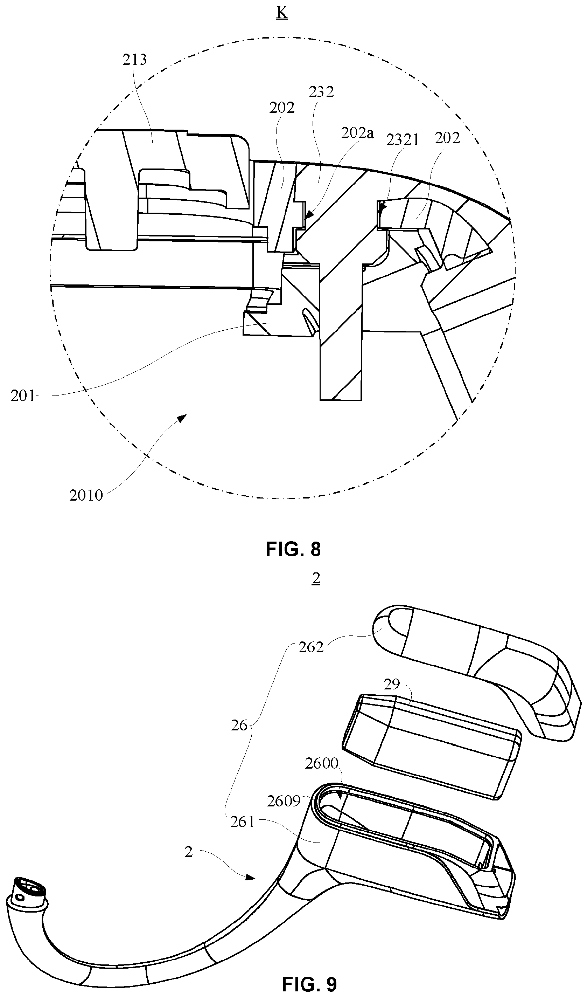

In combination with FIG. 9, a battery 29 may be provided within the accommodation cavity 2010. In some embodiments, the battery 29 is provided in one of the housing assemblies 20 of the two ear hook assemblies 2, and the circuit board 28 is provided in the other housing assembly 20. The two housing assemblies 20 may be the same or different.

In some embodiments, one side of the circuit board 28 may be connected to wires within the accommodation cavity 2010, and the other side of the circuit board 28 is close to the open end 2011 and abuts against the key assembly 21. The circuit board 28 may be assembled into accommodation cavity 2010 via the open end 2011. The circuit board 28 may be limited within the accommodation cavity 2010 by covering the housing 202 on the open end 2011 of the housing 201. By making the housing 202 cover the glue slot 210, the headphone 100 may be made more aesthetically pleasing. The housing 202 may also limit a portion of the key assembly 21 within the accommodation cavity, thereby preventing the key assembly 21 from detaching from the housing 201. In some embodiments, the housing 202 partially or fully blocks the glue slot 210.

A glue may be disposed between the key assembly 21 and the housing 201. Here, the glue is a generic term, and the glue may be of various forms, such as a solid glue, a liquid glue, or a semi-solid glue, etc., which is used to serve a sealing or fixing function. The glue may form a seal between the key assembly 21 and the housing 201 to improve a waterproof performance of the headphone 100. The glue may also act as an adhesive fixing. When dispensing the glue, the glue, for example, is in a form of a fluid, and a curing of the glue occurs after a period of time.

If the glue slot 210 is not provided, the glue needs to be pre-applied between the key assembly 21 and the housing 201 in an insert direction before the insertion and installation of the key assembly 21. In the insertion and installation of the key assembly 21, the key assembly 21 may squeeze the glue into the accommodation cavity 2010, thereby affecting the normal operation of the headphone 100. The glue slot 210 may be used to accommodate the glue. By providing the glue slot 210, the dispensing of the glue after the insertion and installation of the key assembly 21 is performed, this effectively prevents the glue from being pressed into the accommodation cavity 2010 by the key assembly 21. By disposing the glue slot 210 to be visible from the outside of the housing 201 through the open end 2011, it is convenient to perform a dispensing operation of the glue and control the amount of glue dispensed, thereby reducing the probability of poor sealing of the headphone 100 due to little glue dispensed, and reducing the probability of glue seeping out to the outer surface of the housing 201 or seeping into the accommodation cavity 2010 due to too much glue being dispensed, so as to minimize an adverse effect on an appearance of the headphone 100 and a working state of the headphone 100.

As shown in FIG. 4, FIG. 6, and FIG. 8, the key assembly 21 may include a key support 211 with an annular bump 2110 disposed on an outer wall surface, an annular support platform 2012 is disposed on an inner wall surface of the housing 201, the annular bump 2110 is supported on the annular support platform 2012, and the annular bump 2110 sinks for a specific distance relative to the open end 2011. On a side of the annular bump 2110 facing the open end 2011, the outer wall surface of the key support 211 and the inner wall surface of the first housing 201 cooperate with each other to form the glue slot 210.

By disposing the annular bump 2110 to be supported on the annular support platform 2012, the annular support platform 2012 may limit the motion of the key support 211 toward the accommodation cavity 2010, enabling the key support 211 to be stably supported on the housing 201. While assembling the key support 211, the annular support platform 2012 serves to position the key support 211, making it easy to install the key support 211 in place, and improve assembly efficiency. Additionally, the annular bump 2110 is supported on the annular support platform 2012 to make a flow path for the glue to flow into the accommodation cavity 2010 narrow and zigzagging, which reduces the flow of the glue from the glue slot 210 to the accommodation cavity 2010 when dispensing the glue.

By setting the annular bump 2110 to sink for a specific distance relative to the open end 2011, the annular bump 2110 may form a bottom wall of the glue slot 210. Compared with forming the glue slot 210 in an integrally molded manner, forming the glue slot 210 in a discrete molding manner by making the key support 211 and the housing 201 abut against each other makes the assembly of the headphone 100 more flexible, thereby facilitating assembly.

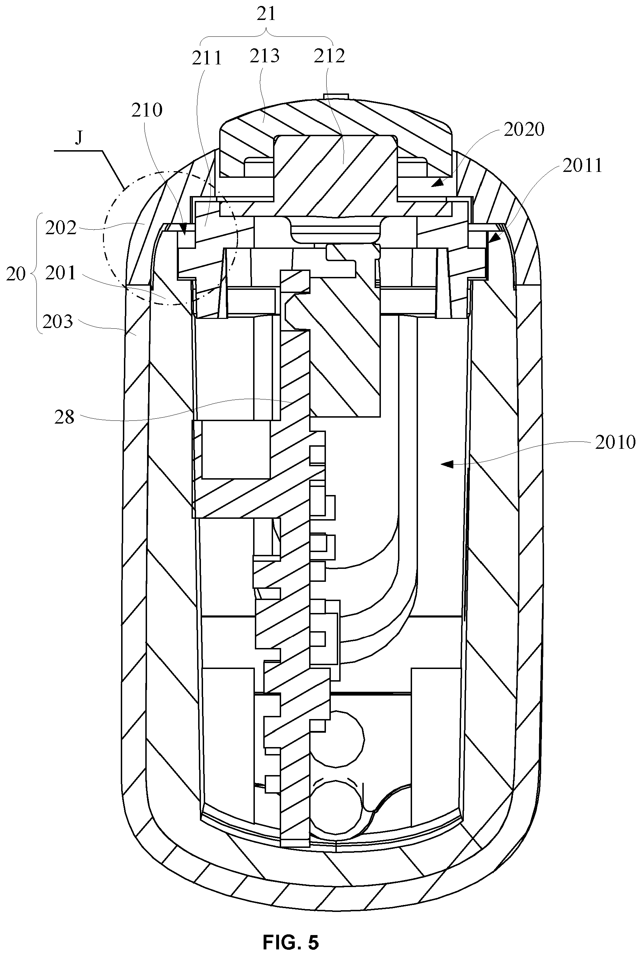

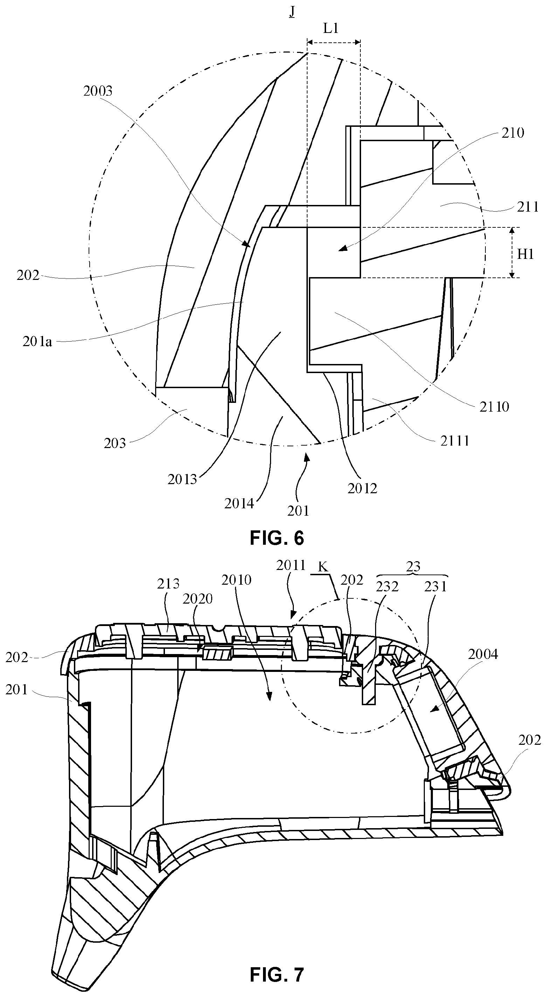

In some embodiments, as shown in FIG. 5 and FIG. 6, an outer end surface of the key support 211 that is away from the accommodation cavity 2010 protrudes from the open end 2011, and the key assembly 21 includes an elastic pressing member 212 disposed on the outer end surface. The housing 202 is disposed with a keyhole 2020, and the elastic pressing member 212 is exposed through the keyhole 2020. By setting the outer end surface of the key support 211 that is away from the accommodation cavity 2010 to protrude from the open end 2011, the flow of glue toward the key assembly 21 may be limited when the glue in the glue slot 210 overflows.

When the user presses a side of the key assembly 21 that is away from the accommodation cavity 2010, the elastic pressing member 212 may be elastically deformed.
The elastic pressing member 212 may be restored when the user releases the key assembly 21. The pressing action of the user may be transmitted to a switch circuit on the circuit board 28 through the elastic deformation or the deformation restore of the elastic pressing member 212, thereby triggering the circuit board 28 to operate. By disposing the keyhole 2020, the elastic deformation or the deformation restore of the elastic pressing member 212 may be allowed such that the user-applied pressing action is transmitted to the circuit board 28.

In some embodiments, as shown in FIG. 5, the key assembly 21 includes an outer pressing member 213. A portion of the outer pressing member 213 is inserted into the keyhole 2020, and another portion of the outer pressing member 213 is disposed protruding from an outer surface of the housing 202 to be pressed by the user. The outer pressing member 213 abuts against the elastic pressing member 212, and the pressing action of the user may be transferred to the elastic pressing member 212 through the outer pressing member 213.

As shown in FIG. 5 and FIG. 6, in the insert direction of the key assembly 21 relative to the accommodation cavity 2010, the housing 201 includes a first wall portion 2013 and a second wall portion 2014 connected to each other, the second wall portion 2014 is located on a side of the first wall portion 2013 that is away from the open end 2011, and the annular support platform 2012 is located at a connection between the first wall portion 2013 and the second wall portion 2014. Specifically, an inner wall surface of the first wall portion 2013 and an inner wall surface of the second wall portion 2014 are connected by the annular support platform 2012. The key support 211 includes a socket portion 2111 disposed on a side of the annular bump 2110 that is away from the open end 2011, and the socket portion 2111 is inserted into a space enclosed by the second wall portion 2014.

In some embodiments, an outer circumference of the insert portion 2111 may match an inner circumference of the second wall portion 2014. The second wall portion 2014 may position the insert portion 2111, and limit the relative motion of the key support 211 and the housing 201, so that the glue slot 210 exists stably, which is conducive to dispensing the glue.

As shown in FIG. 5 and FIG. 6, the housing assembly 20 further includes an elastic covering layer 203 covered on an outer surface of the first housing 203. On the side of the open end 2011, the housing 201 has an exposed portion 201a that is not covered by the elastic covering layer 203. The exposed portion 201a is inserted within the housing 202, and the exposed portion 201a of the housing 202 abuts against the elastic covering layer 203 in an insert direction in which the exposed portion 201a is inserted into the housing 202.

By providing the elastic covering layer 203 on the outer surface of the housing 201, the comfort of the user when holding the headphone 100 is improved, and friction is also increased. By inserting the exposed portion 201a of the housing 201 into the housing 202, the housing 201 may position the housing 202, which limits the relative motion of the housing 201 and the housing 202 and improves a connection stability between the housing 201 and the housing 202.

By setting the exposed portion 201a of the housing 201 to be not covered by the elastic covering layer 203, the elastic covering layer 203 may not interfere with the connection between the housing 201 and the housing 202. By setting the housing 202 to abut against the elastic covering layer 203 in the insert direction of the exposed portion 201a relative to the housing 202, the outer surface of the housing 202 and the outer surface of the elastic covering layer 203 can be flush at the abutment, which on the one hand makes the housing 202 and the elastic covering layer 203 more tightly connected at the abutment, which achieves a better sealing effect, reduces an entry of debris and water vapor, and improves a service life of the elastic covering layer 203. On the other hand, the flushness at the abutment reduces the discomfort caused to the user when the abutment is touched, which makes the earphone 100 more integrally and comfortable, and makes the earphone 100 more aesthetically pleasing.

Further, the housing 202 is not covered by the elastic covering layer 203, so that the side of the key assembly 21 that is away from the accommodation cavity 2010 is spaced apart from the elastic covering layer 203, thereby preventing the elastic covering layer 203 from interfering with the user's pressing on the key assembly 21 and affecting a pressing feeling of the user.

As shown in FIG. 5 and FIG. 6, the exposed portion 201a cooperates with the housing 202 to form a glue gap 2003 for connecting the glue slot 210. The glue slot 2003 may accommodate the glue so that a seal is formed between the exposed portion 201a and the housing 202, and the glue may also fix the exposed portion 201a and the housing 202.

In some embodiments, the outer end surface of the key support 211 that is away from the accommodation cavity 2010 may protrude from the open end 2011, such that the glue may flow to the glue gap 2003 when the glue overflows the glue slot 210. In some embodiments, before assembling the housing 201 and the housing 202, the glue dispense may be performed on an outside of the exposed portion 201a or on the inside of the housing 202, such that the glue fills the glue gap 2003 after the exposed portion 201a and the housing 202 cooperate to form the glue gap 2003.

As shown in FIG. 5 and FIG. 6, a depth H1 of at least a portion of the glue slot 210 is greater than or equal to 0.2 mm in the insert direction of the key assembly 21 relative to the accommodation cavity 2010. For example, the depth H1 of at least a portion of the glue slot 210 may be 0.25 mm, 0.3 mm, 0.35 mm, 0.4 mm, or 0.5 mm. In some embodiments, a width L1 of at least a portion of the glue slot 210 is greater than or equal to 0.4 mm in a vertical direction of the insert direction of the key assembly 21 relative to the accommodation cavity 2010. For example, the width L1 of the at least a portion of the glue slot 210 is 0.45 mm, 0.5 mm, 0.55 mm, 0.6 mm, or 0.8 mm.

In such cases, on the one hand, the glue slot 210 may have sufficient glue to have a sufficient sealing or fixing effect, and on the other hand, on the basis that the glue slot 210 can accommodate sufficient glue, as the glue gap 2003 is connected to the glue slot 210, a small amount of glue may overflow into the glue slot 2003, which further seals between the housing 201 and the housing 202, and improves the sealing performance. Further, the glue slot 2003 may retain glue, thus reducing the risk for the glue to seep out to the outer surface of the housing 201r.

As shown in FIG. 3 and FIG. 7, the housing 201 is further provided with a receiving slot 2004 in flow communication with the accommodation cavity 2010. The headphone 100 further includes an interface assembly 22 inserted into the receiving slot 2004, and the housing 202 is disposed to partially cover the interface assembly 22.

The interface assembly 22 may be used to connect to an external power source to charge the headphone 100. The interface assembly 22 may also be used to connect an external device to transfer data between the external device and the headphone 100. For example, the interface assembly 22 is a Type-C interface, or other types of interfaces, such as a mini-USB interface. Further, the interface assembly 22 may be connected to the circuit board 28 within the accommodation cavity 2010. The external device or the external power source may be connected to the interface assembly 22 through the receiving slot 2004.

By disposing the housing 202 to partially block the interface assembly 22, the housing 202 can stop the interface assembly 22, which limits the interface assembly 22 from moving out of the housing 202 in a direction away from the accommodation cavity 2010, which is conducive to a structural stability of the headphone 100, and at the same time facilitates the assembly of the interface assembly 22.

As shown in FIG. 3, FIG. 7, and FIG. 8, the headphone 100 further includes a dustproof plug 23, the dustproof plug 23 includes a plug body 231 and a fixing portion 232, the fixing portion 232 is disposed on the housing 201 between the key assembly 21 and the interface assembly 22 through the housing 202. The plug body 231 is connected to the fixing portion 232, and is used to selectively cover the interface assembly 22.

The dustproof plug 23 protects the interface assembly 22 when covering the interface assembly 22, for example, the dustproof plug 23 is waterproof and dustproof, and can reduce the risk of mechanical damage to the interface assembly 22.

Further, the dustproof plug 23 may have a deformation capability, and by the deformation of the dustproof plug 23, the plug body 231 and the fixing portion 232 may move relative to each other. By moving relative to the fixing portion 232, the plug body 231 may be switchable between blocking the interface assembly 22 and not blocking the interface assembly 22. Specifically, the plug body 231 may block the interface assembly 22 by being inserted into the receiving slot 2004.

As shown in FIG. 7, the fixing portion 232 may extend through the housing 202 and onto the housing 201 between the key assembly 21 and the interface assembly 22, thereby reducing a space taken up by the fixing portion 232 on the outer surface of the housing 202 to improve space utilization. Specifically, the fixing portion 232 may have a groove 2321, and the housing 202 may be provided with a through hole 202a, and the fixing portion 232 is inserted into the housing 202 through the through hole 202a. A hole wall of the through hole 202a may be snapped into the groove 2321, and thus limited within the groove 2321, such that a bottom wall of the groove 2321 faces the hole wall of the through hole 202a, which limits a relative motion of the housing 202 and the fixing portion 232.

The dustproof plug 23 may be made of an elastic material, such as silicone, rubber, etc., so as to facilitate the insertion of the plug body 231 into the receiving slot 2004, facilitate the insertion of the fixing portion 232 into the housing 202, and make the dustproof plug 23 deformable.

As shown in FIGs. 9-11, the ear hook assembly 2 may include a housing assembly 26. The housing assembly 26 includes a housing 261 and a housing 262 that cooperate with each other, with a glue slot 2601 provided on one of the housing 261 and the housing 262. The glue slot 2601 at least includes a first sidewall 2602 close to the interior of the housing assembly 26, a second sidewall 2603 away from the interior of the housing assembly 26, and a bottom wall connecting the first sidewall 2602 and the second sidewall 2603. The other one of the housing 261 and the housing 262 is inserted into the glue slot 2601 to form a first gap 2604 with the first sidewall 2602 and a second gap 2605 with the second sidewall 2603. A width L2 of the first gap 2604 is greater than a width L3 of the second gap 2605 in a spacing direction between the first sidewall 2602 and the second sidewall 2603. The housing 261 may be referred to as a first housing, and the housing 262 may be referred to as a second housing.

For example, the housing 262 is provided with the glue slot 2601, and the housing 261 is inserted into the glue slot 2601.

The housing 261 and the housing 262 may be connected to form an accommodation cavity 2600 between the housing 261 and the housing 262. The accommodation cavity 2600 may be used to accommodate some components of the headphone 100, for example, a battery 29 is disposed within the accommodation cavity 2600. The battery 29 may be used to power the headphone 100.

In some embodiments, as shown in FIG. 4, the circuit board 28 may be provided in the accommodation cavity 2600. The circuit board 28 is used for converting and processing electrical signals to support a realization of various functions of the headphone 100, for example, the circuit board 28 supports the headphone 100 to realize functions such as switching on/off, switching playback contents, increasing/decreasing volume, etc. In some embodiments, the two ear hook assemblies 2 include the housing assembly 20 and the housing assembly 26, one of which is provided with the battery 29, and the other of which is provided with the circuit board 28.

The glue may be provided between the housing 261 and the housing 262. The glue may form a seal between the housing 262 and the housing 261 to improve the waterproof performance of the headphone 100. The glue may also act as a fixation by sticking. When dispensing glue, the glue may be in the form of a fluid, and a curing of the glue may occur after a period of time.

The glue slot 2601 may be used to accommodate the glue. The dispensing operation of the glue is facilitated by setting the glue slot 2601 to be exposed to the outside in an insert direction of the other one of the second of the housing 261 and the housing 262. By providing the glue slot 2601, it is convenient to control the dispensing volume of the glue when dispensing the glue into the glue slot 2601, which reduces the risk of poor sealing of the headphone 100 due to a low dispensing volume of the glue, and reduces a probability of the glue seeping outwardly onto outer surfaces of the housing 261 and the housing 262 or seeping inwardly into the accommodation cavity 2600 due to too much dispensing of the glue, thereby reducing an adverse effect on a working state of the headphone 100 and an appearance of the headphone 100.

The dispensing of the glue may be performed during assembly, and then the other one of the housing 261 and the housing 262 may be inserted into the glue slot 2601 such that the glue fills the first gap 2604 and the second gap 2605, respectively. By setting the width L2 of the first gap 2604 to be greater than the width L3 of the second gap 2605, the second gap 2605 can retain more glue, and in the process of the other one of the second of the housing 261 and the housing 262 being inserted into the glue slot 2601, the glue tends to flow into the second gap 2605, thereby reducing the probability of the glue flowing onto the outer surfaces of the housing 261 and the housing 262, which is conducive to maintaining a good appearance of the headphone 100.

In some embodiments, the other one of the housing 261 and the housing 262 has a connecting boss 2609 inserted within the glue slot 2601.

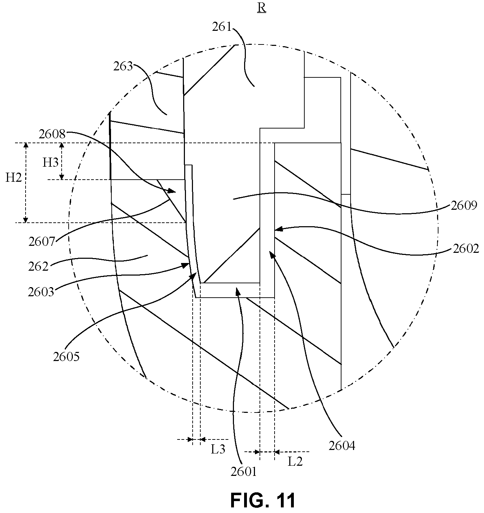

As shown in FIGs. 11-13, the first sidewall 2602 and/or the second sidewall 2603 are provided with a positioning rib 2606 used to limit widths of the first gap 2604 and the second gap 2605. For example, the positioning rib 2606 is provided on the first sidewall 2602. In the spacing direction of the first sidewall 2602 and the second sidewall 2603, the positioning rib 2606 may prevent the other one of the housing 261 and the housing 262 from contacting the first sidewall 2602. When the other one of the second of the housing 261 and the housing 262 abuts against the positioning rib 2606, a raised height of the positioning rib 2606 may be taken as the width L2 of the first gap 2604. When the other one of the housing 261 and the housing 262 does not abut against the positioning rib 2606, the width L2 of the first gap 2604 is greater than the raised height of the positioning rib 2606. Further, at a design stage of the housing assembly 26, in the spacing direction of the first sidewall 2602 and the second sidewall 2603, the width L2 of the first gap 2604 may be greater than or equal to the raised height of the positioning rib 2606, and the width L3 of the second gap 2605 may be less than the raised height of the positioning rib 2606, such that the width L2 of the first gap 2604 is greater than the width L3 of the second gap 2605.

As another example, the positioning rib 2606 is provided on the second sidewall 2603. In the design stage of the housing assembly 26, in the spacing direction of the first sidewall 2602 and the second sidewall 2603, the width L3 of the second gap 2605 may be equal to the raised height of the positioning rib 2606, and the width L2 of the first gap 2604 may be greater than the raised height of the positioning rib 2606, such that the width L2 of the first gap 2604 is greater than the width L3 of the second gap 2605. During the assembly process of inserting the other one of the housing 261 and the housing 262 into the glue slot 2601, the other one of the second of the housing 261 and the housing 262 needs to abut against the positioning rib 2606 so that the width L3 of the second gap 2605 is equal to the raised height of the positioning rib 2606, such that the width L3 of the second gap 2605 is less than the width L2 of the first gap 2604.

As another example, the first sidewall 2602 and the second sidewall 2603 are each provided with the positioning rib 2606, and in the spacing direction of the first sidewall 2602 and the second sidewall 2603, the raised height of the positioning rib 2606 on the first sidewall 2602 is greater than the raised height of the positioning rib 2606 on the second sidewall 2603.
During the assembly process of inserting the other one of the housing 261 and the housing 262 into the glue slot 2601, the other one of the housing 261 and the housing 262 needs to abut against the positioning rib 2606 on the second sidewall 2603 so that the width L2 of the first gap 2604 is greater than the width L3 of the second gap 2605.

In some embodiments, there are two or more positioning ribs 2606, and the two or more positioning ribs 2606 are spaced apart.

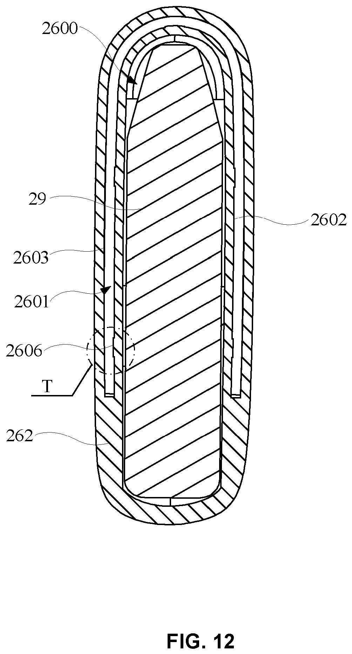

In some embodiments, combining FIGs. 12-13, the positioning rib 2606 is provided on the first sidewall 2602.

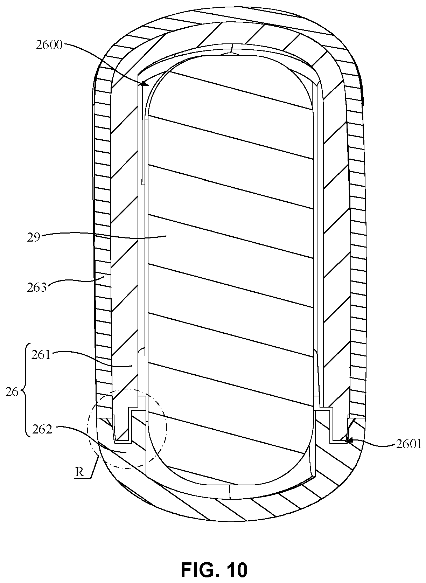

In some embodiments, combining FIGs. 10-11, a difference between the width L2 of the first gap 2604 and the width L3 of the second gap 2605 is greater than or equal to 0.05 mm.

For example, the difference between the width L2 of the first gap 2604 and the width L3 of the second gap 2605 is 0.06 mm, 0.07 mm, 0.08 mm, 0.09 mm, or 0.1 mm.

In such cases, when inserting the second of the housing 261 and the housing 262 into the glue slot 2601, the volume of glue flowing to the second gap 2605 may be within an acceptable range such that the glue may not flow onto the outer surfaces of the housing 261 and the housing 262.

The width L2 of the first gap 2604 may change with the change in the height of the different positions of the first gap 2604 relative to the bottom wall of the glue slot 2601. The width L3 of the second gap 2605 may change with the change in the height of the different positions of the second gap 2605 relative to the bottom wall of the glue slot 2601. Therefore, the width L2 of the first gap 2604 and the width L3 of the second gap 2605 need to be compared at the same height relative to the bottom wall of the glue slot 2601, and a difference between the width L2 of the first gap 2604 and the width L3 of the second gap 2605 need to be calculated at the same height relative to the bottom wall of the glue slot 2601.

As shown in FIGs. 10-11, in the insert direction of the housing 261 and the housing 262, a height of an end of the first gap 2604 that is away from the bottom wall relative to the bottom wall is greater than a height of an end of the second gap 2605 that is away from the bottom wall relative to the bottom wall.

Compared to the second gap 2605, the first gap 2604 has a greater width and the glue tends to flow into the first gap 2604. By setting the height of the end of the first gap 2604 that is away from the bottom wall relative to the bottom wall to be greater than the height of the end of the second gap 2605 that is away from the bottom wall relative to the bottom wall, the first gap 2604 may accommodate more glue, thereby reducing a probability of glue flowing into the interior of the housing assembly 26 through the first gap 2604.

In some embodiments, combining FIGs. 10-11, a height difference H2 between the end of the first gap 2604 that is away from the bottom wall and the end of the second gap 2605 that is away from the bottom wall is greater than or equal to 0.5 mm. For example, the height difference H2 between the end of the first gap 2604 that is away from the bottom wall and the end of the second gap 2605 that is away from the bottom wall is 0.6 mm, 0.7 mm, 0.8 mm, 0.9 mm, or 1 mm.

In such cases, the first gap 2604 may accommodate more glue compared to the second gap 2605 when the other one of the housing 261 and the housing 262 is inserted into the glue slot 2601, so that more glue flows toward the first gap 2064 during squeezing, and the volume of the glue flowing into the interior of the housing assembly 26 through the second gap 2604 is within an acceptable range, or so that the glue does not flow into the interior of the housing assembly 26.

As shown in FIGs. 10-11, the glue slot 2601 includes a third sidewall 2607 connected to the first sidewall 2602, the third sidewall 2607 is farther away from the bottom wall of the glue slot 2601 than the first sidewall 2602. A third gap 2608 is formed between the other one of the housing 261 and the housing 262 and the third sidewall 2607. A width of the third gap 2608 gradually increases in a direction away from the bottom wall. For example, the third sidewall 2607 is disposed on the housing 262 and forms the third gap 2608 between the housing 262 and the housing 261.

The third gap 2608 may be used to accommodate the glue overflowing from the second gap 2605 when more glue flows into the second gap 2605 and overflows from the second gap 2605. By disposing the third gap 2608, the risk of the glue flowing from the second gap 2605 onto the outer surfaces of the housing 261 and the housing 262 may be reduced.

In the spacing direction, by setting the width of the third gap 2608 to gradually increase in the direction away from the bottom wall of the glue slot 2601, the amount of glue accommodated by the third gap 2608 can be increased, which further reduces the risk of the glue flowing onto the outer surface of the housing 261 and the housing 262.

In some embodiments, the third sidewall 2607 may also act as a guide when inserting the other one of the housing 261 and the housing 262 into the glue slot 2601, thereby facilitating the insertion of the other one of the second of the housing 261 and the housing 262 into the glue slot 2601 and improving the assembly efficiency.

As shown in FIGs. 10-11, the width of a portion of the third gap 2608 may be greater than the width L2 of the first gap 2604.

The width of the portion of the third gap 2608 close to the bottom wall of the glue slot 2601 is relatively small, thereby reducing the volume of glue accommodated by the third gap 2608. By setting the width of the portion of the third gap 2608 that is away from the bottom wall of the glue slot 2601 to be greater than the width L2 of the first gap 2604, the volume of glue accommodated by the third gap 2608 may be increased, so as to reduce the risk of the glue flowing onto the outer surfaces of the housing 261 and the housing 262.

As shown in FIGs. 10-11, the height of the end of the first gap 2604 that is away from the bottom wall of the glue slot 2601 relative to the bottom wall of the glue slot 2601 is greater than the height of the third gap 2608 that is away from the bottom wall of the glue slot 2601 relative to the bottom wall of the glue slot 2601, i.e., there is a height difference H3.

By setting the height of the end of the first gap 2604 that is away from the bottom wall of the glue slot 2601 relative to the bottom wall of the glue slot 2601 to be greater than the height of the end of the third gap 2608 that is away from the bottom wall of the glue slot 2601 relative to the bottom wall of the glue slot 2601, the first gap 2604 may accommodate more glue, thereby reducing the probability of the glue flowing into the interior of the housing assembly 26.

On the other hand, the first sidewall 2602 may act as a limit. Specifically, the third gap 2608 may act as a guide, such that when inserting the other one of the housing 261 and the housing 262 into the glue slot 2601, the other one of the housing 261 and the housing 262 moves toward the first sidewall 2602. By setting the height of the end of the first gap 2604 that is away from the bottom wall relative to the bottom wall to be greater than the height of the end of the third gap 2608 that is away from the bottom wall relative to the bottom wall, when the other one of the housing 261 and housing 262 moves toward the first sidewall 2602, the first sidewall 2602 limits the other one of the housing 261 and housing 262, so that the other one of the housing 261 and the housing 262 can be inserted smoothly into the glue slot 2601, and the assembly efficiency may be improved.

As shown in FIGs. 10-11, the housing assembly 26 may include an elastic covering layer 263 partially covered on an outer surface of the housing 261, the glue slot 2601 is provided on the housing 262, and an exposed portion of the housing 261 that is not covered by the elastic covering layer 263 is inserted within the glue slot 2601.

Specifically, the exposed portion of the housing 261 that is not covered by the elastic covering layer 263 may be the connecting boss 2609.

Disposing the elastic covering layer 263 on the outer surface of the housing 261 improves the comfort of the user when holding the headphone 100 and increases friction.

By inserting the exposed portion of the housing 261 into the glue slot 2601, the housing 261 may position the housing 262, which limits the relative motion of the housing 261 and the housing 262, and increases a connection stability between the housing 261 and the housing 262.

By setting the exposed portion of the housing 261 not to be covered by the elastic covering layer 263, the interference of the elastic covering layer 263 on the connection between the housing 261 and the housing 262 within the glue slot 2601 may be avoided.

Further, the housing 262 abuts against the elastic covering layer 263 in the insert direction of the exposed portion relative to the housing 262, which causes the outer surface of the housing 262 and the outer surface of the elastic covering layer 263 to be flush at the abutment, which on the one hand makes the housing 262 and the elastic covering layer 263 closer at the abutment, provides a better sealing effect, reduces an entry of debris and water vapor, and improves the service life of the elastic covering layer 263. On the other hand, the flushness at the abutment reduces the discomfort brought to the user when being touched, making the headphone 100 more integrative and more comfortable, and also making the headphone 100 more aesthetically pleasing.

Further, the housing 262 is not covered by the elastic covering layer 263, an area of the outer surface of the housing 262 may be smaller than an area of the outer surface of the housing 261, and the user tends to hold the housing 261 to hold the headphone 100, so that the outer surface of the housing 262 is not provided with the elastic covering layer 263.

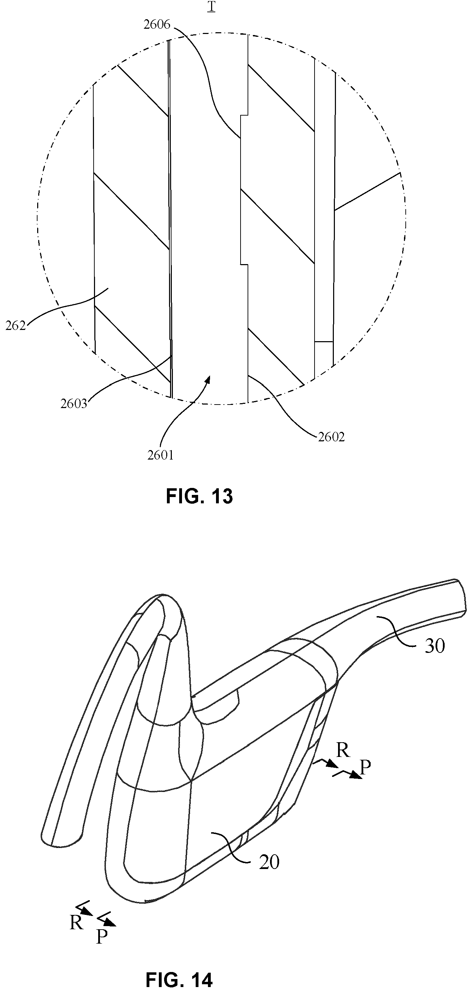

As shown in FIGs. 14-15, the ear hook assembly 2 may include the housing assembly 20, the interface assembly 22, a stopper 25, the circuit board 28, and a wire assembly 24. In some embodiments, the headphone 100 also includes a wearing assembly 30 and the dustproof plug 23.

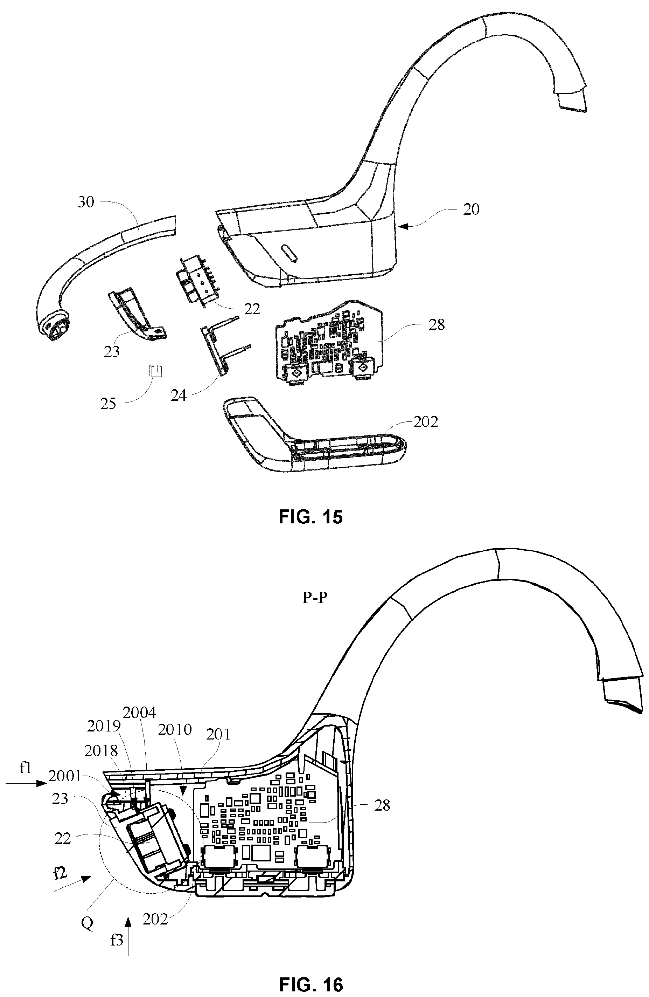

In some embodiments, as shown in FIGs. 15-18, the housing assembly 20 includes the housing 201 provided with the receiving slot 2004 and the accommodation cavity 2010 in communication with the receiving slot 2004. The interface assembly 22 is inserted into the receiving slot 2004. The circuit board 28 is disposed within the accommodation cavity 2010. The wire assembly 24 electrically connects the circuit board 28 to the interface assembly 22.

By setting the interface assembly 22 and the circuit board 28 separately, instead of fixing and soldering the interface assembly 22 directly to the circuit board 28, and by utilizing the wire assembly 24 to connect the interface assembly 22 and the circuit board 28, a freedom of a mounting position and a mounting posture of the interface assembly 22 may be improved. In such cases, the receiving slot 2004 and the accommodation cavity 2010 in communication with the receiving slot 2004 are reasonably provided inside the housing 201 for accommodating the interface assembly 22 and the circuit board 28, respectively, which is favorable to a flexible application of the space inside the housing 201, and facilitate the installation of the interface assembly 22 and the circuit board 28, respectively, thereby facilitating the assembly of the headphone 100 and effectively reducing difficulty of assembling the headphone 100.

As shown in FIG. 16, the circuit board 28 is spaced apart from the interface assembly 22 in an insert direction f2 of the interface assembly 22 relative to the receiving slot 2004.

By maintaining a certain spacing between the interface assembly 22 and the circuit board 28 in the insert direction f2 of the interface assembly 22 relative to the receiving slot 2004, the occupation of the space of the accommodation cavity 2010 accommodating the circuit board 28 by the interface assembly 22 is effectively reduced, a possibility of the interface assembly 22 interfering with the circuit board 28 is effectively reduced, which improves effectiveness of the operation of the interface assembly 22 and the circuit board 28 and improves a reliability and a service life of the headphone 100.

In some embodiments, as shown in FIGs. 16-19, the housing 201 is provided with a socket 2001 spaced apart from the receiving slot 2004 by a partition wall 2018. The partition wall 2018 is provided with a connection slot 2019 connecting the socket 2001 and the receiving slot 2004. The wearing assembly 30 includes an insert member 33 including an insert body 331 inserted into the socket 2001. The stopper 25 is provided to be inserted into the socket 2001 from the receiving slot 2004 through the connection slot 2019, and is configured to lock the insert body 331 into the socket 2001. The interface assembly 22 is inserted into the receiving slot 2004.

By setting the partition wall 2018 to form the socket 2001 and the receiving slot 2004 isolated from each other for inserting the insert member 33 and the interface assembly 22, respectively, the insert member 33 and the interface assembly 22 are effectively limited and installed, so that the insert member 33 and the interface assembly 22 do not interfere with each other and do not occupy each other's space, which facilitates assembling and disassembling, and is conducive to maintenance and care of the headphone 100. The connection slot 2019 provided on the partition wall 2018 is used for inserting the stopper 25 for locking the socket body 331 into the socket 2001, so that the stopper 25 limits the insert body 331 into the socket 2001 without being exposed outside the housing 201, which improves the stability and reliability of the installation of the insert body 331 without affecting an appearance of the headphones 100 and effectively improves aesthetics of the headphone 100. In addition, disposing the connection slot 2019 on the partition wall 2018 improves the utilization rate of the space, realizes a close arrangement inside the housing assembly 20, and reduces the volume of the headphone 100.

In some embodiments, a rear end portion of the housing assembly 20 (i.e., an end portion with a slot opening of the receiving slot 2004 and a slot opening of the socket 2001, which is away from an ear in a wearing state) is inclined, which, on the one hand, is configured to reduce a volume and weight of the entire housing assembly 2 such that the entire headphone 100 miniaturized, and on the other hand, makes it easy for mold opening and demolding in the manufacturing and reduces the difficulty of manufacturing, thereby making the headphone 100 more aesthetically pleasing. By setting the interface assembly 22 at the inclined rear end portion, a sloping region that is not easy to be utilized may be efficiently utilized such that the overall structure is more compact with a higher space utilization. Additionally, the interface assembly 22 is disposed at the rear end portion instead of a lower side, which has less impact on the stability of the placement of the headphone when in use. Additionally, wires connecting the interface assembly 22 are less likely to shake relative to the interface assembly 22 and cause unnecessary friction, and the wires are less likely to rub against the region where they are placed.

In some embodiments, the interface assembly 22 and the housing 202 are fixed by dispensing glue for securing the interface assembly 22 to the housing 202 and for securing and sealing of the connection position between the interface assembly 22 and the housing 202. In some embodiments, the interface assembly 22 and the housing 202 are fixed by providing a silicone member (not shown in the figure), the silicone member is interference fit with the interface assembly 22 and the housing 202, and the interface assembly 22 is fixed to the housing 202 by snap screws and other fixing structures, so as to realize the fixing of the interface assembly 22 and the housing 202 as well as the fixing and sealing of the connection position between the interface assembly 22 and the housing 202.

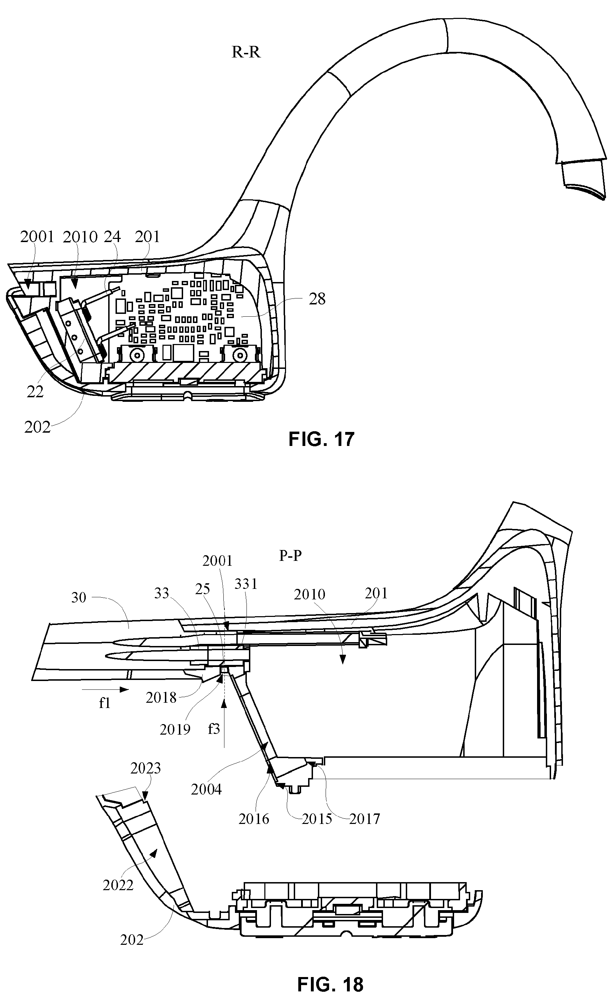

Further, as shown in FIG. 18, a position of the connection slot 2019 is set such that the stopper 25 is visible from outside of the housing 201 in an insert direction f3 of the stopper 25 relative to the connection slot 2019.

The connection slot 2019 is visible from the outside of the housing 201, i.e., the position of the connection slot 2019 is exposed to the outside of the housing 201, such that the stopper 25, when inserted in the insert direction f3 relative to the connection slot 2019, has a clear position and is easy to operate, which effectively reduces the difficulty of assembly and disassembly.

In some embodiments, as shown in FIGs. 16-18, the housing assembly 20 further includes the housing 202, which is connected to the housing 201 and is used to cover the connection slot 2019 and the stopper 25.

The housing 202 is connected to the housing 201 to cover the connection slot 2019 and the stopper 25 to make the connection slot 2019 and the stopper 25 invisible from the outside of the headphone 100, which improves the aesthetics of the headphone 100. Compared to an integrated housing, by disposing the separate and connected housing 201 and the housing 202, the stopper 25 may be installed when the housing 202 is not connected to the housing 201, which is easy to operate and less difficult to install. After inserting the stopper 25, by connecting the housing 202 and the housing 201, the connection slot 2019 and the stopper 25 may be covered. In such cases, the assembly operability of the earphone 100 is ensured, and the aesthetics of the earphone 100 is effectively guaranteed.

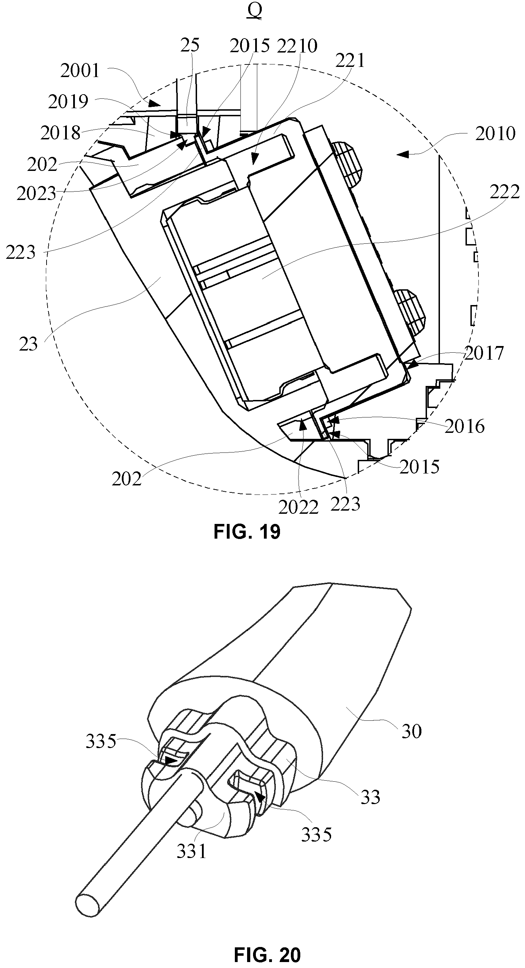

Further, as shown in FIG. 16 and FIG. 19, the housing 202 is further configured to stop the stopper 25 in an opposite direction of the insert direction f3.

The housing 202, while covering the connection slot 2019 and the stopper 25, may stop the stopper 25 to support the stopper 25, which avoids the stopper 25 from moving in the opposite direction of the insert direction f3 and causing the insert member 33 to loosen and affects the use of the headphone 100, so as to enhance the stability of the connection and improve the service life of the headphone 100.

In some embodiments, as shown in FIG. 18 and FIG. 19, the interface assembly 22 includes a main body portion 221 and a wire arrangement portion 222, the main body portion 221 is provided with a first guiding cavity 2210, and the wire arrangement portion 222 is at least partially accommodated in the first guiding cavity 2210. The housing 202 is provided with a second guiding cavity 2022, the housing 202 is connected to the housing 201, and the second guiding cavity 2022 is docked with the first guiding cavity 2210.

By connecting the housing 202 to the housing 201 to enable the first guiding cavity 2210 and the second guiding cavity 2022 to dock against each other, the interface assembly 22 does not need to provide a complete guiding cavity for the wire arrangement portion 222, instead, the second guiding cavity 2022 is constructed using the housing 202, which reduces an overall volume of the housing assembly 20 and makes the housing assembly 20 more compact.

The wire arrangement portion 222 protrudes from the first guiding cavity 2210 and extends into the second guiding cavity 2022. In the above manner, the first guiding cavity 2210 and the second guiding cavity 2022 accommodate the wire arrangement portion 222 together, which facilitates the insertion of the wire arrangement portion 222.

As shown in FIG. 19, the interface assembly 22 may further include a flange portion 223, and the flange portion 223 is disposed on a side of the main body portion 221 away from the accommodation cavity 2010. The housing 201 is provided with a first support platform 2015, the flange portion 223 is supported on the first support platform 2015, and the housing 202 is provided to cover the flange portion 223.

By disposing the flange portion 223 and the first support platform 2015, and supporting the flange portion 223 on the first support platform 2015, the support of the first support platform 2015 for the flange portion 223 may improve the stability and reliability of the installation of the interface assembly 22, and effectively limit the installation of the interface assembly 22. Additionally, the housing 202 is provided to cover the flange portion 223, and the flange portion 223 is not exposed to the outside of the housing assembly 20, so that the flange portion 223 is invisible to the user from the outside of the headphone 100, which effectively enhances the aesthetics of the headphone 100.

As shown in FIG. 19, the housing 202 may further press the flange portion 223 against the first support platform 2015.

By pressing the flange portion 223 using the housing 202, the flange portion 223 is pressed on the first support platform 2015, and the flange portion 223 is tightly supported on the first support platform 2015, which improves a support effect of the first support platform 2015 on the flange portion 223. Further, the limited installation of the housing assembly 20 on the interface assembly 22 is more stable and reliable, which reduces the possibility of shaking of the interface assembly 22 and effectively improves the fixing effect.

As shown in FIG. 19, the first support platform 2015 is provided with the glue slot 2016, and the flange portion 223 covers the glue slot 2016.

The glue slot 2016 may accommodate glue, so that when the installation of the interface assembly 22 is performed, the glue in the glue slot 2016 may fill the gap between the interface assembly 22 and the housing 201, thereby improving the sealing. The use of the glue effectively fixes the interface assembly 22, which increases the stability of the connection between the interface assembly 22 and the housing 201.

As shown in FIG. 18 and FIG. 19, the first support platform 2015, the flange portion 223, and the glue slot 2016 surround the receiving slot 2004 in a closed manner around an insert direction f2 of the interface assembly 22 relative to the receiving slot 2004.

The first support platform 2015, the flange portion 223, and the glue slot 2016 all surround the receiving slot 2004 in a closed manner around the interface assembly 22, i.e., the flange portion 223 is supported around the interface assembly 22 on the first support platform 2015, which effectively increases a contact area between the first support platform 2015 and the flange portion 223, and makes a support force provided by the first support platform 2015 to the interface assembly 22 uniform and reliable, thereby effectively improving the support effect of the first support platform 2015 on the interface assembly 22, improving the fixation effect, and improving the service life of the headphone 100. Additionally, the glue slot 2016 of the interface assembly 22 that closed around the receiving slot 2004 allows for a complete dispensing of glue around the receiving slot 2004 when the interface assembly 22 is installed, which effectively improves the sealing effect.

In some embodiments, in combination with FIG. 18 and FIG. 19, the housing 201 is further provided with a second support platform 2017, and an inner end surface of the main body portion 221 facing the accommodation cavity 2010 is supported on the second support platform 2017.

By disposing the second support platform 2017 to support the inner end surface of the side of the main body portion 221 facing the accommodation cavity 2010, the first support platform 2015 and the second support platform 2017 jointly support the interface assembly 22, thereby improving the stability of the interface assembly 22, and reducing a possibility of shaking of the interface assembly 22.

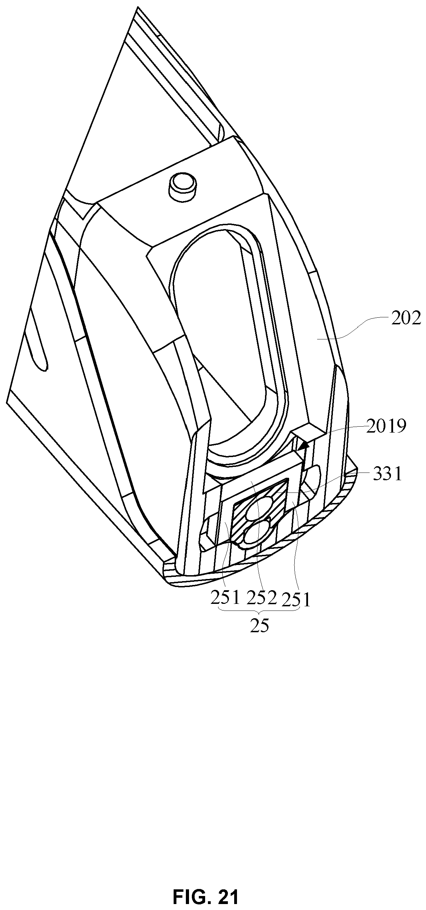

In some embodiments, as shown in FIG. 20 and FIG. 21, the stopper 25 includes two pins 251 disposed side-by-side and a connection portion 252 connecting the two pins 251. The insert body 331 is disposed with two snapping slots 335, the two pins 251 are respectively inserted into the two snapping slots 335. The connection portion 252 is disposed in the connection slot 2019 and forms an interference with a slot wall of the connection slot 2019 at least in an opposite direction of an insert direction f1 of the insert body 331 relative to the socket 2001.

The stopper 25 is used for locking and limiting the insert body 331 to realize the limited installation of the insert member 33. By disposing two pins 251 side-by-side on the stopper 25, and providing the insert body 331 with two snapping slots 335 to cooperate with the two pins 251 to connect the stopper 25 and the insert body 331, the two pins 251 may be correspondingly inserted into the two snapping slots 335 to improve the stability of the connection and improve the locking effect.

The connecting portion 252 is disposed in the connection slot 2019, and the connection portion 252 forms an interference with the slot wall of the connection slot 2019 at least in the opposite direction of the insertion direction f1, so as to make the slot wall of the connecting slot 2019 provide a supporting force to the connecting portion 252, which reduces an overall height of the stopper 25 and improves the stability and reliability of the connection.

As shown in FIG.19 and FIG.21, the connecting portion 252 may be sunk into the connection slot 2019, and the housing 202 may be provided with a glue slot 2023 that is in flow communication with the connection slot 2019.

The glue slot 2023 may accommodate the glue, so that when the installation of the housing 202 is performed, the glue in the glue slot 2023 fills, for example, the gap between the housing 202 and the connection slot 2019 and the gap between the housing 202 and the connecting portion 252, to improve the sealing. The use of the glue may effectively fix the stopper 25 and the housing 202, which increases the stability of the connection between the housing 201, the housing 202, and the stopper 25.

In some embodiments, as shown in FIG. 19, the partition wall 2018 is further provided with the first support platform 2015. The flange portion 223 is supported on the first support platform 2015.

By providing the flange portion 223 and the support platform 2015 and making the flange portion 223 supported on the first support platform 2015, the stability and reliability of the installation of the interface assembly 22 are improved, and the installation of the interface assembly 22 is effectively limited.

As shown in FIG. 19, the flange portion 223 may be further configured to stop the stopper 25 in the opposite direction of the insert direction f3 of the stopper 25 relative to the connection slot 2019.

By disposing the flange portion 223 to stop the stopper 25 in the opposite direction of the insert direction f3 of the stopper 25 relative to the connection slot 2019, the support force is further provided for the stopper 25 to further stop and limit the stopper 25, making the structure more stable and solid, reducing the possibility of shaking and loosening of the stopper 25, and increasing the service life of the headphone 100.

In some embodiments, as shown in FIG. 16, the insert direction f2 of the interface assembly 22 relative to the receiving slot 2004 is set at an acute angle to the insert direction f1 of the insert member 33 relative to the socket 2001. Specifically, the insert direction f1 of the insert body 331 relative to the socket 2001 is disposed at an acute angle to the insert direction f2 of the interface assembly 22 relative to the receiving slot 2004. The second support surface 2017 is disposed on a side of the interface assembly 22 that is away from the insert member 33, and an inner end surface of the main body portion 221 is suspended toward the insert member 33.

On the basis that the insert direction f2 of the interface assembly 22 relative to the receiving slot 2004 is disposed at the acute angle to the insert direction f1 of the insert member 33 relative to the socket 2001, the inner end surface of the main body portion 221 is supported on the second support platform 2017 on the side away from the insert member 33 and is suspended on the side facing the insert member 33, which effectively supports and fixes interface assembly 22 and reduces the volume of the housing assembly 20, thereby improving the utilization of space inside the housing assembly 20.

In some embodiments, as shown in FIG. 16, a side of the interface assembly 22 facing the inner side of the housing 201 is arranged to exceed the partition wall 2018 in the insert direction f2 of the interface assembly 22 relative to the receiving slot 2004.

On the basis that the insert direction f2 of the interface assembly 22 relative to the receiving slot 2004 is set at the acute angle to the insert direction f1 of the insert member 33 relative to the socket 2001, the interface assembly 22 exceeds the partition wall 2018 such that the space within the housing assembly 20 can be further fully utilized without interfering with the socket body 331, thereby improving the utilization of the space inside the housing assembly 20, making the structure inside the housing assembly 20 more compact, and improving an integrality and a tightness of the structure, thereby reducing the volume of the housing assembly 20, making the headphone 100 more convenient to wear and carry, and improving the use experience of the headphone 100.

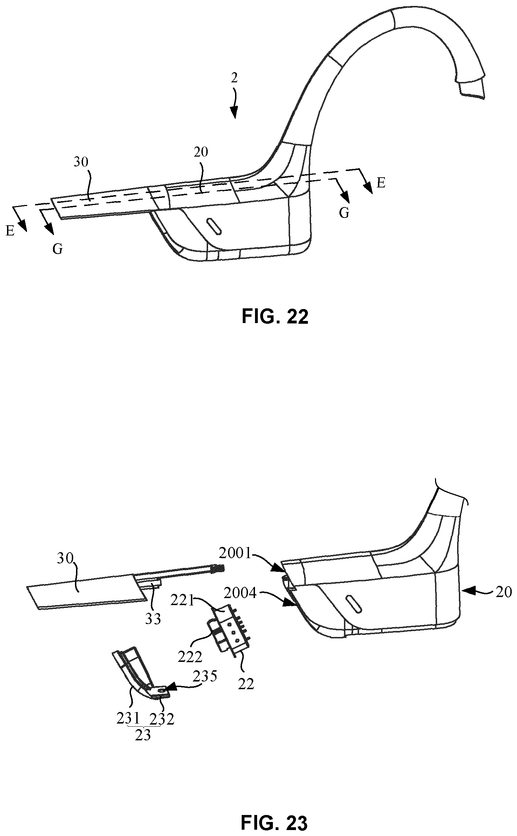

The interface assembly 22 is inserted into the receiving slot 2004 as shown in FIGs. 22-24. The interface assembly 22 is configured to be plugged into the corresponding external interface such that the headphone 100 can be electrically connected to other devices for functions such as charging, transmission, etc. The dustproof plug 23 may be partially fixed to the housing assembly 20 through the cooperation between the housing 201 and the housing 202, and can selectively block the interface assembly 22.

In some embodiments, the wearing assembly 30 may include the insert member 33. The insert member 33 may be inserted into the housing assembly 20 to enable the wearing assembly 30 to be fixed to the housing 201. The wearing assembly 30 is used to be worn on an auricle, the neck, the back of the head, etc. to place the headphone 100 at a certain position.

In some embodiments, as shown in FIGs. 23-24, the headphone 100 further includes the key assembly 21 disposed within the housing 201 and exposed through the housing 202. Specifically, the key assembly 21 is used to be subjected to a user operation for realizing a human-machine interaction function with the headphone 100 by the user.

Specifically, as shown in FIGs. 23-24, the dustproof plug 23 may include the plug body 231 and the fixing portion 232, and the fixing portion 232 may be limited to the housing 201 by the housing 202. The plug body 231 is connected to the fixing portion 232 and is used to selectively block the interface assembly 22.

The plug body 231 can move relative to the interface assembly 22 so as to selectively block the interface assembly 22 or expose the interface assembly 22. The fixing portion 232 connects the plug body 231 to pull the plug body 231, such that the plug body 231 is still connected to the housing assembly 20 through the fixing portion 232 when exposing the interface assembly 22, and thus is less likely to fall off the headphone 100.

By disposing the dustproof plug 23 to selectively block the interface assembly 22, the interface assembly 22 may be blocked by the dustproof plug 23 when not connected to the corresponding plug for use, so as to avoid a situation where impurities, such as dust particles, falling into the interface assembly 22, clogging the interface assembly 22, and affecting the use of the interface assembly 22. Further, as the fixing portion 232 of the dustproof plug 23 is limited to the housing 201 through the housing 202 such that the housing 201 and the housing 202 are used to fix the dustproof plug 23 together, the assembly of the dustproof plug 23 may be more stable, and the dustproof plug 23 does not need to be directly fixed to the housing 201. In such cases, there is no need to provide a corresponding fixed position on the housing 201, which simplifies the structures of the housing 201 and the housing 202, as well as an assembly manner of the dustproof plug 23.

As shown in FIGs. 23-28, the main body portion 221 is provided with the first guiding cavity 2210, the wire arrangement portion 222 is at least partially accommodated in the first guiding cavity 2210, the housing 202 is provided with the second guiding cavity 2022, the second guiding cavity 2022 is docked with the first guiding cavity 2210, and the plug body 231 is configured to be selectively inserted into or remove from the first guiding cavity 2210.

Specifically, the main body portion 221 is configured to be inserted into an external interface corresponding to the interface assembly 22. The wire arrangement portion 222 protrudes from the first guiding cavity 2210 and extends into the second guiding cavity 2022. The wire arrangement portion 222 is used to enable the headphone 100 to electrically connect the external device through the wire arrangement portion 222 after the external interface is inserted. In the above manner, the first guiding cavity 2210 and the second guiding cavity 2022 collectively accommodate the wire arrangement portion 222, which enables the wire arrangement portion 222 to be conveniently connected.

In some embodiments, the plug body 231 may be inserted into the first guiding cavity 2210 through the second guiding cavity 2022 to block the interface assembly 22. A shape of the plug body 231 may be adapted to the first guiding cavity 2210 and the wire arrangement portion 222 such that the wire arrangement portion 222 is less likely to impede the insertion of the plug body 231 into the first guiding cavity 2210. By disposing the second guiding cavity 2022 to dock with the first guiding cavity 2210, the interface assembly 22 does not need to have a complete guiding cavity, which reduces the volume of the interface assembly 22 and the volume of the entire housing assembly 20.

Through the docking of the second guiding cavity 2022 and the first guiding cavity 2210, the interface assembly 22 may be pressed between the housing 201 and the housing 202, thereby facilitating the installation of the interface assembly 22. The insert portion of the plug body 231 may adapt to the second guiding cavity 2022 and the first guiding cavity 2210, so that the plug body 231, even after being inserted into the first guiding cavity 2210, can be fixed relative to the interface assembly 22 instead of easily falling out of the first guiding cavity 2210 and the second guiding cavity 2022.

In some embodiments, when the plug body 231 is inserted into the first guiding cavity 2210, a side of the plug body 231 that is away from the interface assembly 22 may completely cover the second guiding cavity 2022 to completely block the interface assembly 22, such that impurities such as dust and metal particles are not easy to fall into the interface assembly 22.

In some embodiments, the plug body 231 may be an elastomer made of an elastic material, such as silicone, rubber, etc., so as to facilitate a selective insertion of the plug body 231 into or out of the first guiding cavity 2210 while avoiding the plug body 231 from damaging the interface assembly 22.

By disposing the second guiding cavity 2022 and the first guiding cavity 2210, the plug body 231 can be selectively inserted into or moved out of the first guiding cavity 2210 so as to facilitate the plug body 231 to selectively block the interface assembly 22, thereby preventing the impurities such as the dust, the metal particles, etc. from falling into the interface assembly 22.

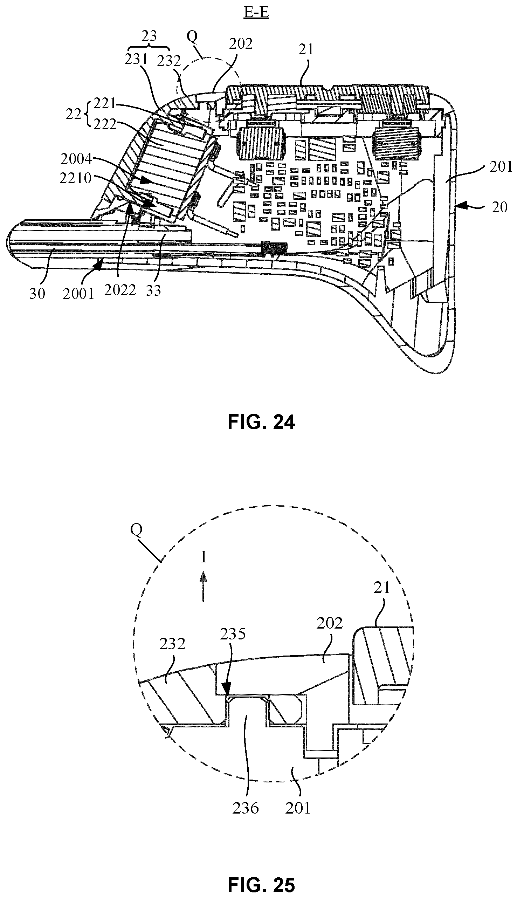

In some embodiments, as shown in FIGs. 23-28, the insert member 33 is inserted within the socket 2001, and the fixing portion 232 is located on a side of the interface assembly 22 that is away from the insert member 33. Specifically, as shown in FIG. 24, the fixing portion 232 and the insert member 33 are located on both sides of the interface assembly 22, so that positions of the dustproof plug 23 and the insert member 33 do not interact with each other, and the space of the headphone 100 is reduced, and the space utilization of the headphone 100 is improved.

In some embodiments, the fixing portion 232 is disposed between the key assembly 21 and the interface assembly 22 such that the utilization space of the headphone 100 is saved, the volume of the headphone 100 is reduced, and the space utilization of the headphone 100 is improved.

In some embodiments, as shown in FIGs. 24-29, the housing 202 may be connected to the housing 201, and the fixing portion 232 is pressed to the housing 201. Specifically, the housing 202 may cover the housing 201, and the fixing portion 232 may be partially disposed on the housing 201 and limited to the housing 201 while being pressed by the housing 202. In such cases, the assembly of the dustproof plug 23 may be more convenient, and it may also be easier for the headphone 100 to be disassembled for maintenance.

In some embodiments, as shown in FIG. 25, a positioning hole 235 may be provided on one of the fixing portion 232 and the housing 201, and a positioning post 236 may be provided on the other one of the fixing portion 232 and the housing 201. The positioning post 236 is inserted within the positioning hole 235, and the housing 202 presses the fixing portion 232 on the housing 201 at a periphery of the positioning hole 235.

By disposing the positioning hole 235 and the positioning post 236, the fixing portion 232 and the housing 201 may snap together, and by utilizing the housing 202 to press the positioning post 236 to the positioning hole 235 at the periphery of the positioning hole 235, the fixing portion 232 may be fixed on the housing 201. In such cases, the assembly and disassembly of the fixing portion 232, the housing 201, and the housing 202 are facilitated, the structure of the headphone 100 is more compact, and the fixing portion 232 may be securely limited to the housing 201.

In some embodiments, the fixing portion 232 may be an elastomer, the positioning hole 235 may be provided on the fixing portion 232, the positioning post 236 may be provided on the housing 201, and the positioning post 236 may be inserted into the positioning hole 235 at a depth less than a hole depth of the positioning hole 235. Specifically, the positions of the positioning hole 235 on the fixing portion 232 and the positioning post 236 on the housing 201 may correspond to each other, the positioning post 236 is inserted into the positioning hole 235, and an extension direction of the positioning post 236 may be as shown by the I arrow in FIG. 25. The housing 202 may be pressed toward the direction of the positioning post 236 in an extension direction of the positioning post 236, so that the fixing portion 232 is fixed to the housing 201 after the housing 201 is fixedly connected to the housing 202.

The fixing portion 232 may be the elastomer such as silicone, rubber, etc. By setting the insertion depth of the positioning holes 235 less than the hole depth of the positioning hole 235, the fixing portion 232 has a certain compression space in the extension direction of the positioning post 236 and may be elastically deformed when pressed by the housing 202 and the housing 201, and thus is fixed and limited by the housing 201 and the housing 202. In such cases, the fixing portion 232 may be more securely limited to the housing 201 and is not prone to loosening, which improves structural tightness and solidity of the headphone 100.

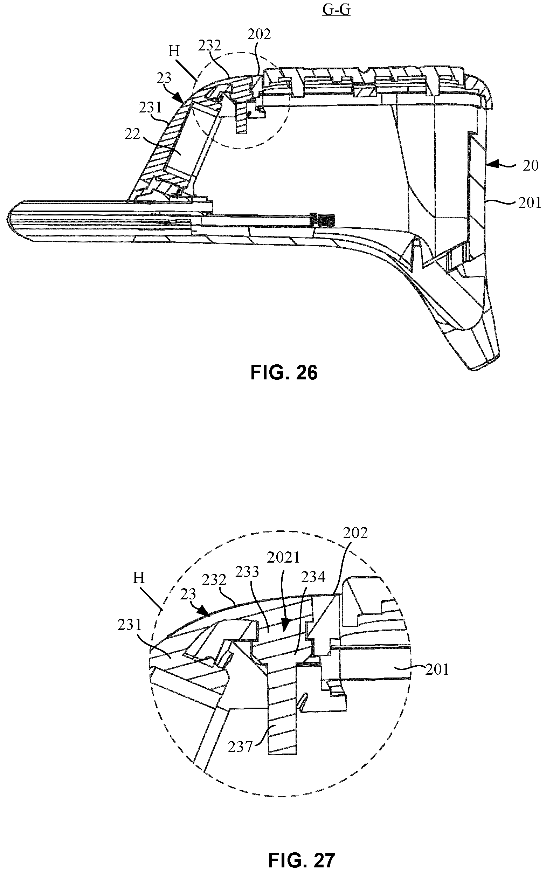

In other embodiments, as shown in FIG. 26 and FIG. 27, the housing 202 may be connected to the housing 201, and the fixing portion 232 may be connected to the housing 202. The housing 202 and the housing 201 may cover and be fixed to each other, and since the fixing portion 232 is connected to the housing 202, the fixing portion 232 is limited to the housing 201.

In some embodiments, as shown in FIG. 27, a mounting hole 2021 may be provided on the housing 202, and the dustproof plug 23 may further include a connection post 233 connected to the fixing portion 232 and a stop portion 234 connected to the connection post 233. The connection post 233 is inserted into the mounting hole 2021, and the fixing portion 232 and the stop portion 234 are locked on both sides of the housing 202, respectively.

Specifically, one end of the fixing portion 232 may be connected to the plug body 231, and an end away from the plug body 231 is connected to the connection post 233. The fixing portion 232 and the stop portion 234 are respectively disposed at two ends of the connection post 233, and the plug body 231 is fixedly connected to the housing 202 via the fixing portion 232 and the stop portion 234. The stop portion 234 is disposed in a gap between the housing 202 and the housing 201, and is capable of being blocked by the housing 202 and fixed relative to the housing 202 and the housing 201 so that it is less likely to move in the direction of the housing 202 and fall off the housing 202.

In some embodiments, the stop portion 234 is an elastomer and is configured to pass through the mounting hole 2021 under the action of an external traction force. The stop portion may be an elastomer such as silicone, rubber, etc., which can be elastically deformed under an external force and recover to its original state when the external force is removed.

Based on the descriptions above, the dustproof plug 23 may further include a traction portion 237 connected to an end of the stop portion 234 that is away from the connection post 233. The traction portion 237 is used to be pulled to drive the stop portion 234 to pass through the mounting hole 2021 under the action of the external traction force, thereby realizing the assembly of the fixing portion 232. After passing through the mounting hole 2021, the stop portion 234 may be compressed in the gap between the housing 202 and the housing 201, so that the stop portion 234 is fixed relative to the housing 202 and the housing 201 and is not easy to rotate, loosen, or disengage from the mounting hole 2021 and make the dustproof plug 23 to fall. After the stop portion 234 passes through the mounting hole 2021 and is fixed, the traction portion 237 may be removed, for example, by shearing, which saves an internal space of the housing 201 and improves the space utilization of the headphone 100.

By setting the stop portion 234 as the elastomer, the dustproof plug 23 may be easy to be assembled to simplify the assembling process of the headphone 100, which facilitates the disassembly and maintenance of the dustproof plug 23, and makes the connection structure of the headphone 100 more tight and stable.

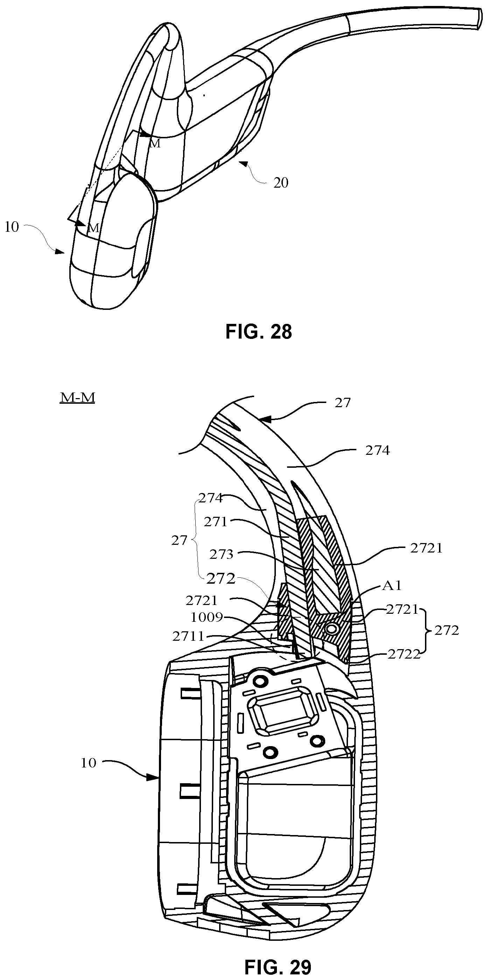

As shown in FIGs. 28-31, the housing assembly 10 is provided with a socket 1008. The wearing assembly 27 includes a wire assembly 271 and an insert member 272. The insert member 272 includes an insert body 2721 configured to be inserted into the socket 1008. The wire assembly 271 is threaded through the insert body 2721 and has an exposed portion 2711 that is exposed from an inner end surface of the insert body 2721 facing an interior of the housing assembly 10. The insert member 272 further includes an annular rib 2722 protruding from the inner end surface, the annular rib 2722 being provided around the exposed portion 2711 such that an inner annular surface of the annular rib 2722 forms a first glue slot 2723 at a periphery of the exposed portion 2711. The annular rib 2722 and the insert body 2721 may be integrally molded. The annular rib 2722 may also be considered as a part of the insert body 2721.

A waterproof seal is achieved by filling the first glue slot 2723 with glue, which in turn seals an assembly gap between the wire assembly 271 and the insert body 2721. Furthermore, as the first glue slot 2723 is formed by the inner annular surface of the annular rib 2722 at the periphery of the exposed portion 2711 of the wire assembly 271, the wire assembly 271 and the insert body 2721 may be connected more tightly, thereby improving the stability of the connection between the wire assembly 271 and the insert body 2721.

Referring to FIGs. 28-33, in some embodiments, the outer annular surface of the annular rib 2722 cooperates with a slot wall to form a second glue slot 2724. The second glue slot 2724 is configured to accommodate the glue for filling the assembly gap between the housing assembly 10 and the insert body 2721 to achieve a waterproof seal. Further, by filling the second glue slot 2724 with the glue, the housing assembly 10 may be connected to the insert body 2721 more tightly, thereby preventing the insert body 2721 from wobbling in the housing assembly 10.

In some embodiments, the second glue slot 2724 is disposed in an annular shape at the periphery of the annular rib 2722, allowing the glue to achieve a more comprehensive seal in an annular shape at the periphery of the annular rib 2722 to reduce an entrance of water vapor, etc. into the housing assembly 10 through the gap between the insert body 2721 and the slot wall of the insert slot 1008.

Referring to FIGs. 28-32, in some embodiments, a depth of the first glue slot 2723 is greater than a depth of the second glue slot 2724 in an insert direction of the insert member 272 relative to the socket 1008, so as to enable the first glue slot 2723 to accommodate more glue, which improves a fixing effect and a sealing effect on the wire assembly 271, and the second glue slot 2724 with the relatively small depth enables the insert body 2721 to have more region contacting the insert slot 1008, thereby improving the insert fixing effect, and the glue in the second glue slot 2724 may also provide a good sealing effect.

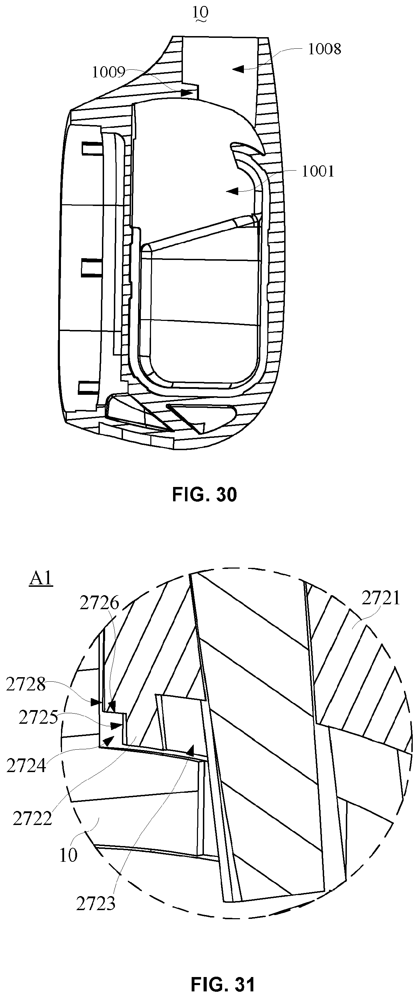

In some embodiments, as shown in FIG. 31, the outer annular surface of the annular rib 2722 includes a first sub-outer annular surface 2725, a connection surface 2726, and a second sub-outer annular surface 2728. The first sub-outer annular surface 2725 is closer to the interior of the housing assembly 10 than the second sub-outer annular surface 2728. A gap between the first sub-outer annular surface 2725 and the socket wall of the socket 1008 is greater than a gap between the second sub-outer annular surface 2728 and the socket wall, the connection surface 2726 is connected between the first sub-outer annular surface 2725 and the second sub-outer annular surface 2728, and the first sub-outer annular surface 2725, the connection surface 2726, and the socket wall of the socket 1008 cooperate to form the second glue slot 2724.

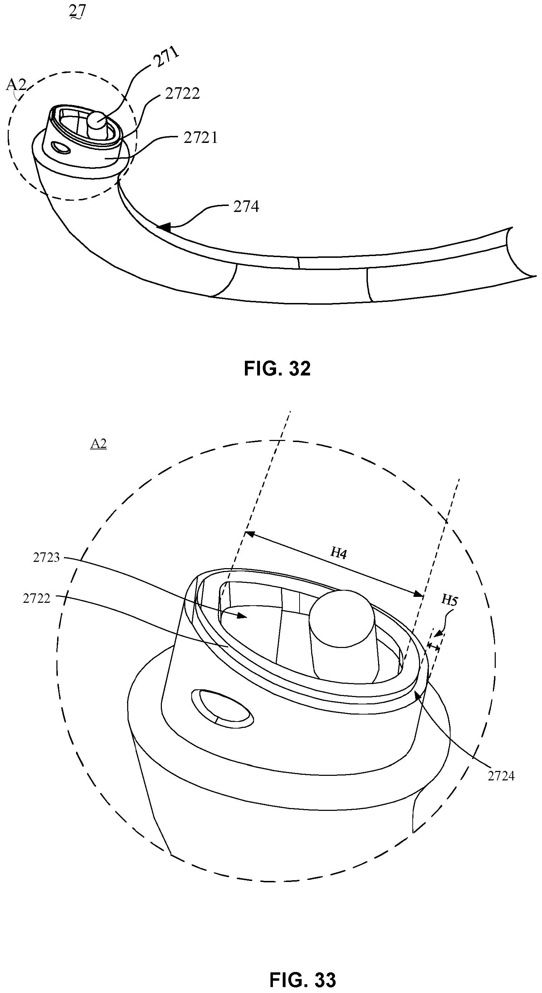

Referring to FIGs. 28-33, in some embodiments, a width H4 of the first glue slot 2723 is greater than a width H5 of the second glue slot 2724 in a vertical direction of the insert direction of the insert member 272 relative to the insert 1008. The width H5 shown in FIG. 33 is labeled on the annular rib 2722 only and should be understood as a distance between the first sub-outer annular surface 2725 of the annular rib 2722 and a corresponding socket wall of the socket 1008. In such cases, on the one hand, the first glue slot 2723 can accommodate more glue, which improves the fixing effect and the sealing effect of the wire assembly 271, and on the other hand, the sealing effect of the second glue slot 2724 is satisfied with less glue. Furthermore, as the width H5 of the second glue slot 2724 is smaller than the width H4 of the first glue slot 2723, the distance between the outer annular surface of the annular rib 2722 and the socket wall may be shortened, which improves a glue pressure within the second glue slot 2724such that the glue within the second glue slot 2724 may further enter the gap between the outer annular surface of the annular rib 2722 and the socket wall.

Referring to FIG. 29 and FIG. 30, in some embodiments, the housing assembly 10 is provided with the accommodation cavity 1001, the accommodation cavity 1001 is in communication with the socket 1008, and the housing assembly 10 includes a limiting member 1009 disposed between the accommodation cavity 1001 and the socket 1008. The limiting member 1009 is used to abut against the insert body 2721, and specifically abut against the annular rib 2722, to limit the insert depth of the insert body 2721 relative to the socket 1008.

Referring to FIG. 30 and FIG. 31, in some embodiments, at least a portion of the first glue slot 2723 and/or the second glue slot 2724 are not blocked by the limiting member 1009 when viewed from the accommodation cavity 1001, so as to facilitate application of the glue into the first glue slot 2723 and the second glue slot 2724. For example, at least a portion of the first glue slot 2723 is not blocked by the limiting member 1009. As another example, at least a portion of the second glue slot 2724 is not blocked by the limiting member 1009. As another example, at least a portion of the first glue slot 2723 and a portion of the second glue slot 2724 are not blocked by the limiting member 1009. In such cases, the glue can be filled from a side where the first glue slot 2723 and/or the second glue slot 2724 is not blocked by the limiting member 1009.

Referring to FIG. 29 and FIG. 30, in some embodiments, viewed from the accommodation cavity 1001, an area of a region of the first glue slot 2723 that is blocked by the limiting member 1009 is less than an area of a region that is not blocked by the limiting member 1009 and/or an area of a region of the second glue slot 2724 that is blocked by the limiting member 1009 is less than an area of a region that is not blocked by the restriction member 1009.

As the area of the region blocked by the limiting member 1009 is smaller than the area of the region not blocked by the limiting member 1009, the area of the region available for the application of the glue is effectively increased, which further improves the efficiency of glue application.

Referring to FIG. 29 and FIG. 30, in some embodiments, a slot opening position of the region of the first glue slot 2723 that is not blocked by the limiting member 1009 is closer to the accommodation cavity 1001 than a slot opening position of the region of the first glue slot 2723 that is blocked by the limiting member 1009, and/or a slot opening position of the region of the second glue slot 2724 that is not blocked by the limiting member 1009 is closer to the accommodation cavity 1001 than a slot opening position of the region of the second glue slot 2724 that is blocked by the limiting member 1009. In such cases, the glue application is further facilitated, and the probability of the glue application is improved.

In some embodiments, in a direction from a side of the first glue slot 2723 that is not blocked by the limiting member 1009 to a side of the first glue slot 2723 that is blocked by the limiting member 1009, a bottom of the first glue slot 2723 is inclined toward a direction away from the accommodation cavity 1001, and/or a bottom of the second glue slot 2724 is inclined toward the direction away from the accommodation cavity 1001.

Referring to FIG. 29, in some embodiments, the wearing assembly 27 further includes an elastic metal wire 273 and a covering member 274, the elastic metal wire 273 and the wire assembly 274 are configured to penetrate the insert body 1721 from an outer end surface of the insert body 1721 that is away from the interior of the housing assembly 10, and the covering member 274 is configured to wrap a side of the insert body 1721 that is away from the interior of the housing assembly 10 along the circumference of the insert body 2721 and expose a side of the insert body 1721 that faces the interior of the housing assembly 10.

Referring to FIG. 29 and FIG. 30, the covering member 274 circumferentially wraps the insert body 2721 that is not inserted into the socket 1008. The covering member 274 may be a rubber member or a silicone member, so as to serve as waterproofing and protect the elastic metal wire 273, the wire assembly 271, and the insert body 2721 that are not inserted into the housing assembly 10, which is conducive to improving a cosmetic quality of the headphone 100.

The above content describes a core assembly 1 and an ear hook assembly 2, and the following describes the structure of a rear hook assembly 3, etc. of the headphone 100.

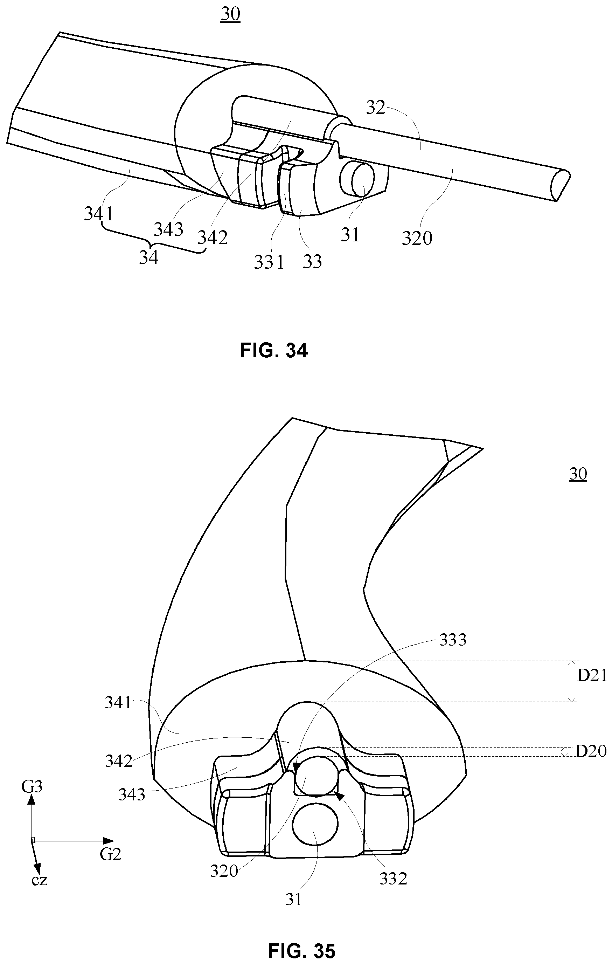

As shown in FIG. 34, the rear hook assembly 3 includes the wearing assembly 30. The wearing assembly 30 may include an elastic metal wire 31, a wire assembly 32, the insert member 33, and a covering assembly 34.

In some embodiments, the elastic metal wire 31 may be made of titanium alloy, or other elastic metals or alloys, which is not limited herein. The insert member 33 is fixed to an end of the elastic metal wire 31.

In some embodiments, the insert member 33 further includes the insert body 331, the wire assembly 32 has an exposed portion 320 that is exposed from a body covering portion 341 and extends to the insert body 331. In some embodiments, the covering assembly 34 includes the body covering portion 341 and an extended covering portion 342. The extended covering portion 342 is used to cover the periphery of the elastic metal wire 31 and the wire assembly 32. The extended covering portion 342 is used to cover the periphery of the exposed portion 320 of the wire assembly 32, and the extended covering portion 342 partially covers the insert body 331 at the circumference of the insert body 331.

The inventor of the present disclosure has found in a long-term study that, after the above-mentioned wearing assembly 30 is connected to the housing assemblies 20, 26, etc., the glue is further applied for fixing, and the glue often directly contacts the wire assembly 32. Due to poor adhesion between the plastic material (e.g., Teflon) of the outer surface of the wire assembly 32 and the glue, the fixing effect may be unstable, and the sealing between the connection structure and the housing assembly 20/26 may also be poor. Since the wire assembly 32 is relatively soft, the yield rate of the connection between the wearing assembly 30 and the housing assemblies 20 and 26 may be low. Therefore, by adding the extended covering portion 342 to protect the exposed portion 320, the glue may not directly contact the exposed portion of the wire assembly 32, and a bonding effect between the extended covering portion 342 and the glue may be enhanced by the extended wrapping portion 342, thereby improving the fixing effect, the sealing effect, as well as an installation yield of the wearing assembly 30. Furthermore, the extended covering portion 342 partially covers the insert body 331 in a circumferential direction of the insert body 331, so that the insert body 331 is partially exposed in the circumferential direction to ensure structural strength during the connection.

As shown in FIG. 35, in some embodiments, a thickness D20 of the extended covering portion 342 is less than a thickness D21 of the body covering portion 341, and the extended wrapping portion 342 is connected to the body covering portion 341 and forms a stage structure.

In some embodiments, the extended covering portion 342 is integrally molded with the body covering portion 341. Specifically, the extended covering portion 342 is integrally molded with the body covering portion 341 by injection, molding, etc. The extended covering portion 342 may also be disposed separately from the body covering portion 341. For example, the extended covering portion 342 is pre-molded in a tubular shape and is sleeved on the periphery of the exposed portion 320.

In some embodiments, a surface of the insert body 331 is disposed with an accommodation slot 332. The accommodation slot 332 has an opening 333 on a cross-section perpendicular to an insert direction cz of the insert body 331. The exposed portion 320 is provided within the accommodation slot 332, and the extended covering portion 342 is integrally molded with the body covering portion 341. When viewed from the opening direction of the opening 333 of the accommodation slot 332, at least a portion of the exposed portion 320 disposed within the accommodation slot 332 has a region visible from the outside, and the region visible from the outside is covered by the extended covering portion 342. Further, a length direction of the accommodation slot 332 is arranged along the insert direction cz, and it may be understood that the length direction of the accommodation slot 332 is the same as the insert direction cz.

In some embodiments, the extended covering portion 342 fills the gap between the exposed portion 320 and the slot wall of the accommodation slot 332.

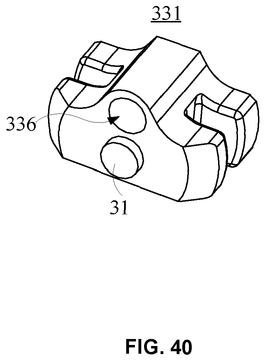

In some embodiments, as shown in FIG. 35 and FIG. 40, the covering assembly 34 further includes an extended insert portion 343 integrally molded with the body covering portion 341, and the extended insert portion 343 contacts an end surface of the insert body 331 facing the body covering portion 341. The extended insert portion 343 is capable of being inserted into the socket 2001 of the housing assembly 20 together with the insert body 331. By providing the extended insert portion 343, an insert depth of the insert body 331 may be increased, which improves the structural stability.

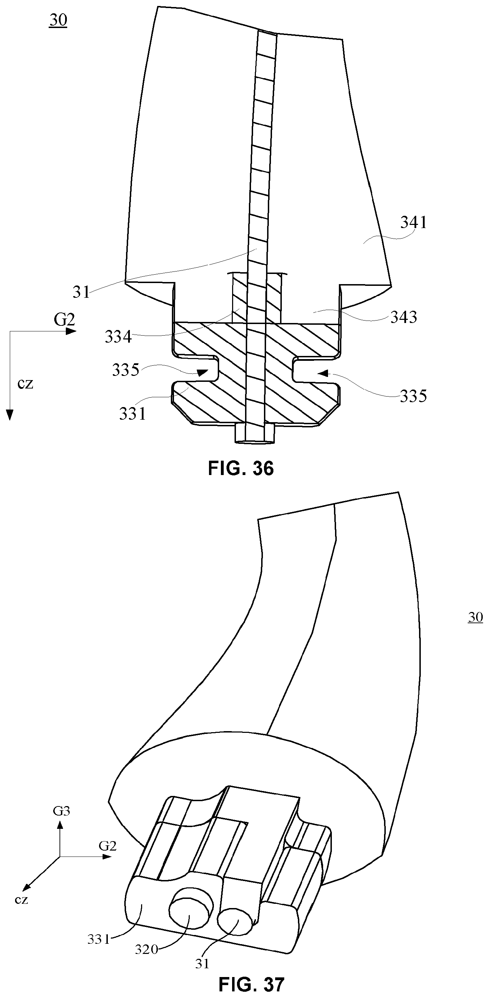

As shown in FIG. 36, the insert member 33 further includes an extended positioning portion 334 protruding from an end surface of the insert body 331, and the extended positioning portion 334 is embedded within the extended insert portion 343. By providing the expended positioning portion 334 embedded within the extended insert portion 343, an area of a contact interface between the insert body 331 and the covering assembly 34 is increased, and the stability between the insert body 331 and the covering assembly 34 is improved.

In other embodiments, when the extended insert portion 343 is not provided, the expended positioning portion 334 protrudes from the end surface of the insert body 331 facing the body covering portion 341, and the expended positioning portion 334 is embedded in the body covering portion 341, which also increases the area of the contact interface between the inserted body 331 and the covering assembly 34.

In some embodiments, the elastic metal wire 31 is threaded through the expended positioning portion 334 to improve the fixing effect between the elastic metal wire 31 and the insert member 33.

In some embodiments, as shown in FIG. 35, on the cross-section perpendicular to the insert direction cz of the insert body 331, the insert body 331 has a length direction G2 and a width direction G3. The exposed portion 320 and the elastic metal wire 31 may be spaced apart in the width direction G3. By disposing the exposed portion 320 and the elastic metal wire 31 to be spaced apart in the width direction G3 of the insert body 331, the machinability of the insert member 33 is increased.

As shown in FIG. 37, in some other embodiments, the exposed portion 320 is spaced apart from the elastic metal wire 31 in the length direction G2. As the size of the insert body 331 in the width direction G3 is relatively limited, and by disposing the exposed portion 320 to be spaced apart from the elastic metal wire 31 in the length direction G2 of the insert body 331, the space utilization of the insert member 33 is improved.

As shown in FIG. 36, the insert body 331 is provided with two snapping slots 335 spaced apart in the length direction G2, and the exposed portion 320 and the elastic metal wire 31 are disposed between the two snapping slots 335 in the length direction G2.

In some embodiments, a covering width of the insert body 331 by the extended covering portion 342 in a circumferential direction of the insert body 331 is less than or equal to a quarter of the maximum circumferential length of the insert body 331. The maximum circumferential length is the maximum circumference of the insert body 331 in a reference plane perpendicular to the insert direction cz when the exposed portion 320 and the extended covering portion are not provided.

The housing assembly 20 of the ear hook assembly 2 is provided with the socket 2001, and the extended covering portion 342 as well as the extended insert portion 343 described above are inserted into the socket 2001 with the insert body 331. Further, the headphone 100 also includes the glue (not shown) used to seal the gap between the insert body 331 and the socket wall of the socket 2001 and the gap between the expended covering portion 342 and the socket wall of the socket 2001. A wetting degree of the glue to the surface of the extended covering portion 342 is greater than a wetting degree of the glue to the surface of the wire assembly 32.

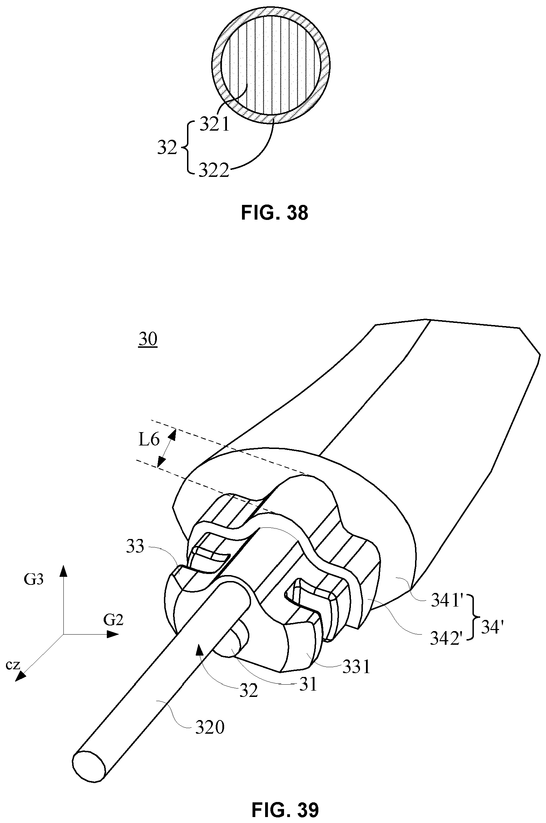

As shown in FIG. 38, the wire assembly 32 includes a wire body 321 and an insulating covering 322 coated on the periphery of the wire body 321. In some embodiments, the material of the insulating covering 322 is polytetrafluoroethylene, and the material of the expended covering portion 342 is silicone. The wetting degree of the glue to the surface of the expended covering portion 342 is greater than the wetting degree of the glue to the surface of the insulating covering 322. In such cases, the bonding effect between the glue and the extended covering portion 342 is better, which effectively improves the sealing effect and the fixing effect such that the headphone 100 may have a good waterproof effect.

One exemplary structure of the wearing assembly 30 is described above, and another exemplary structure of the wearing assembly 30 is described below.

As shown in FIG. 39, the wearing assembly 30 may specifically include the elastic metal wire 31, the wire assembly 32, the insert member 33, and a covering assembly 34'. The insert member 33 is fixed to an end portion of the elastic metal wire 31. The insert member 33 further includes the insert body 331. The covering assembly 34' includes a body covering portion 341' used to cover the periphery of the elastic wire 31 and the wire assembly 32. The wire assembly 32 has an exposed portion 320 that is exposed from the body covering portion 341' and extends to the insert body 331.

As shown in FIG. 40, the insert body 331 is provided with an aperture 336. The exposed portion 320 of the wire assembly 32 is threaded through the aperture 336. For example, the aperture 336 on the insert body 331 may be pre-formed and the exposed portion 320 is subsequently inserted into and passes through the aperture 336.

By disposing the aperture 336 on the insert body 331 to further protect the exposed portion 320, the glue may not directly contact the exposed portion of the wire assembly 32, and the exposed portion of the wire assembly may be bonded to the glue through the socket body 331 to enhance the bonding effect, thereby improving the fixing effect, the sealing effect, and the installation yield of the wearing assembly 30. Further, the socket body 331 may provide better protection for the wire assembly 32 by disposing the aperture 336 to surround the exposed portion 320.

In some embodiments, an aperture wall of the aperture 336 is closed along the circumference of the exposed portion 320 and surrounds the outer periphery of the exposed portion 320.

In some embodiments, as shown in FIG. 39, the covering assembly 34' further includes an extended covering portion 342' integrally molded with the body covering portion 341'. The extended covering portion 342' covers an end of the insert body 331 facing the body covering portion 341' in the circumferential direction of the insert body 331, and exposes the other end of the insert body 331 that is away from the body covering portion 341', thereby improving the waterproofing effect of the end surface of the insert body 331 facing the body covering portion 341'.

A covering length L6 of the extended covering portion 342' on the insert body 331 is between 0.2 mm and 2.0 mm in the insert direction cz relative to the insert body 331.

Referring to the above embodiments, in some embodiments, the insert member 33 further includes the extended positioning portion 334 (referring to the expended positioning portion shown in FIG. 36) protruding from the end surface of the insert body 331 facing the body covering portion 341', and the extended positioning portion 334 is embedded within the body covering portion 341'. Similarly, the elastic metal wire 31 is threaded within the extended positioning portion 334.

Referring to the above embodiments, on the cross-section perpendicular to the insert direction cz of the insert body 331 relative to the socket 2001, the insert body 331 has the length direction G2 and the width direction G3. In some embodiments, the exposed portion 320 and the elastic metal wire 31 may be spaced apart in the length direction G2, or the exposed portion 320 and the elastic metal wire 31 may be spaced apart in the width direction G3. The machinability of the insert member 33 is improved by spacing apart the exposed portion 320 and the elastic metal wire 31 in the width direction G3 of the insert body 331. A covering of the exposed portion 320 and the elastic metal wire 31 and the setting of the snapping slot may be referred to the above embodiments. The housing assembly 20 of the ear hook assembly 2 is provided with the socket 2001, and the extended covering portion 342' and the aperture 336 described above are inserted into the socket 2001 with the insert body 331.

In some embodiments, the headphone 100 further includes the glue (not shown) used to seal the gap between the slot body 331 and the socket wall of the socket 2001. The wetting degree of the glue on the surface of the slot body 331 is greater than the wetting degree of the glue on the surface of the wire assembly 32.

As shown in FIG. 38, the wire assembly 32 includes the wire body 321 and the insulating covering 322 wrapped at the periphery of the wire body 321, and the wetting degree of the glue on the surface of the extended covering portion 342 is greater than the wetting degree of the glue on the surface of the insulating covering 322.

In some embodiments, the material of the insulating covering 322 may be PTFE, and the material of the insert body 331 may be metal. The material of the extended covering 342 may be silicone. In some embodiments, the material of the insert body 331 may be any one or a combination of one or more metals or alloys, which is not limited herein. By disposing the insulating covering to be a high-temperature-resistant and insulating polytetrafluoroethylene material, the wire body is prevented from melting the insulating covering when excessive heat is generated.

## Claims

1. A headphone (100), comprising:
a housing assembly (20) including a first housing (201) and a second housing (202), the first housing (201) being provided with an accommodation cavity (2010) with at least one open end (2011);
and a key assembly (21);
**characterized in that**:
the key assembly (21) is at least partially inserted into the accommodation cavity (2010) through the open end (2011), the key assembly (21) cooperating with the first housing (201) to form a glue slot (210) visible from the outside of the first housing (201) through the open end (2011), wherein the second housing (202) is arranged on the open end (2011) of the first housing (201) and covers the glue slot (210).

2. The headphone (100) of claim 1, wherein
the key assembly (21) includes a key support (211) with an annular bump (2110) disposed on an outer wall surface,
an annular support platform (2012) is disposed on an inner wall surface of the first housing (201), the annular bump (2110) is supported on the annular support platform (2012), and the annular bump (2110) sinks for a specific distance with respect to the open end (2011), and
on a side of the annular bump (2110) facing the open end (2011), the outer wall surface of the key support (211) and the inner wall surface of the first housing (201) cooperate with each other to form the glue slot (210).

3. The headphone (100) of claim 2, wherein
an outer end surface of the key support . (211) that is away from the accommodation cavity (2010) protrudes from the open end (2011),
the key assembly (21) includes an elastic pressing member (212) provided on the outer end surface,
the second housing (202) is provided with a keyhole (2020), and
the elastic pressing member (212) is exposed through the keyhole (2020).

4. The headphone (100) of claim 3, wherein
the key assembly (21) includes an outer pressing member (213), a portion of the outer pressing member (213) is inserted into the keyhole (2020), and another portion of the outer pressing membe (213) is disposed protruding from an outer surface of the second housing (202), and the outer pressing member (213) abuts against the elastic pressing member (212).

5. The headphone (100) of claim 2, wherein
in an insert direction of the key assembly (21) relative to the accommodation cavity (2010), the first housing (201) includes a first wall portion (2013) and a second wall portion (2014) connected to each other, the second wall portion (2014) being disposed on a side of the first wall portion (2013) away from the open end (2011),
the annular support platform i (2012) is disposed at a connection between the first wall portion (2013) and the second wall portion (2014), and
the key support i (211) includes an insert portion (2111) disposed on a side of the annular bump (2110) away from the open end (2011), the insert portion (2111) being inserted into the second wall portion (2014).

6. The headphone (100) of claim 5, wherein an outer circumference of the insert portion (2111) matches an inner circumference of the second wall portion (2014).

7. The headphone (100) of claim 1, wherein
the housing assembly (20) further includes an elastic covering layer (203) covered on an outer surface of the first housing (201),
on a side where the open end (2011) is located, the first housing (201) has an exposed portion (201a) that is not covered by the elastic covering layer (203), and the exposed portion (201a) is inserted into the second housing (202), and
the second housing (202) abuts against the elastic covering layer (203) in an insertion direction of the exposed portion (201a) relative to the second housing (202).

8. The headphone (100) of claim 7, wherein a side of the key assembly (21) that is away from the accommodation cavity (2010) spaced apart from the elastic covering layer (203).

9. The headphone (100) of claim 7, wherein the exposed portion (201a) cooperates with the second housing (202) to form a glue gap (2003) for connecting the glue slot (210).

10. The headphone (100) of claim 1, wherein a depth of at least a portion of the glue slot (210) is greater than or equal to 0.2 mm in an insert direction of the key assembly (21) relative to the accommodation cavity (2010).

11. The headphone (100) of claim 10, wherein a width of at least a portion of the glue slot (210) is greater than or equal to 0.4 mm in a vertical direction of the insert direction of the key assembly (21) relative to the accommodation cavity (2010).

12. The headphone (100) of claim 1, wherein
the first housing (201) is further provided with a receiving slot (2004) in flow communication with the accommodation cavity (2010),
the headphone (100) further includes an interface assembly (22) inserted into the receiving slot (2004), and
the second housing (202) is configured to partially cover the interface assembly (22).

13. The headphone (100) of claim 12, further including a dustproof plug (23), wherein
the dustproof plug (23) includes a plug body (231) and a fixing portion (232), the fixing portion (232) is disposed on the first housing (201) between the key assembly and the interface assembly (22) through the second housing (202), and
the plug body (231) is connected to the fixing portion (232) and configured to selectively cover the interface assembly (22).

14. The headphone (100) of claim 13, wherein the dustproof plug (23) has a deformation capability.

15. The headphone (100) of claim 13, wherein the fixing portion (232) has a groove (2321), the second housing (202) is provided with a through hole (202a), the fixing portion (232) is inserted into the second housing (202) through the through hole (202a), and a hole wall of the through hole (202a) is snapped into the groove.

## Patentansprüche

1. Kopfhörer (100), umfassend:
eine Gehäusebaugruppe (20), die ein erstes Gehäuse (201) und ein zweites Gehäuse (202) einschließt, wobei das erste Gehäuse (201) mit einem Unterbringungshohlraum (2010) mit mindestens einem offenen Ende (2011) versehen ist;
und eine Tastenbaugruppe (21);
**dadurch gekennzeichnet, dass**:
die Tastenbaugruppe (21) mindestens teilweise durch das offene Ende (2011) in den Unterbringungshohlraum (2010) eingesetzt ist, wobei die Tastenbaugruppe (21) mit dem ersten Gehäuse (201) zusammenwirkt, um einen Klebeschlitz (210) zu bilden, der durch das offene Ende (2011) von der Außenseite des ersten Gehäuses (201) her sichtbar ist, wobei das zweite Gehäuse (202) an dem offenen Ende (2011) des ersten Gehäuses (201) angeordnet ist und den Klebeschlitz (210) abdeckt.

2. Kopfhörer (100) nach Anspruch 1, wobei
die Tastenbaugruppe (21) eine Tastenhalterung (211) mit einer ringförmigen Erhebung (2110) einschließt, die an einer äußeren Wandfläche angeordnet ist,
eine ringförmige Halteplattform (2012) an einer inneren Wandfläche des ersten Gehäuses (201) angeordnet ist, die ringförmige Erhebung (2110) an der ringförmigen Halteplattform (2012) gehalten wird und die ringförmige Erhebung (2110) in Bezug auf das offene Ende (2011) um einen bestimmten Abstand einsinkt, und
auf einer Seite der ringförmigen Erhebung (2110), die dem offenen Ende (2011) zugewandt ist, die äußere Wandfläche der Tastenhalterung (211) und die innere Wandfläche des ersten Gehäuses (201) zusammenwirken, um den Klebeschlitz (210) zu bilden.

3. Kopfhörer (100) nach Anspruch 2, wobei
eine äußere Endfläche der Tastenhalterung (211), die von dem Unterbringungshohlraum (2010) abgewandt ist, von dem offenen Ende (2011) vorspringt,
die Tastenbaugruppe (21) ein elastisches Drückelement (212) einschließt, das an der äußeren Endfläche vorgesehen ist,
das zweite Gehäuse (202) mit einem Tastenloch (2020) versehen ist, und
das elastische Drückelement (212) durch das Tastenloch (2020) freiliegt.

4. Kopfhörer (100) nach Anspruch 3, wobei
die Tastenbaugruppe (21) ein äußeres Drückelement (213) einschließt, ein Abschnitt des äußeren Drückelements (213) in das Tastenloch (2020) eingesetzt ist und ein anderer Abschnitt des äußeren Drückelements (213) von einer äußeren Fläche des zweiten Gehäuses (202) vorspringend angeordnet ist, und das äußere Drückelement (213) an dem elastischen Drückelement (212) anliegt.

5. Kopfhörer (100) nach Anspruch 2, wobei
in einer Einsetzrichtung der Tastenbaugruppe (21) relativ zu dem Unterbringungshohlraum (2010) das erste Gehäuse (201) einen ersten Wandabschnitt (2013) und einen zweiten Wandabschnitt (2014) einschließt, die miteinander verbunden sind, wobei der zweite Wandabschnitt (2014) auf einer Seite des ersten Wandabschnitts (2013) angeordnet ist, die von dem offenen Ende (2011) abgewandt ist,
die ringförmige Halteplattform i (2012) an einer Verbindung zwischen dem ersten Wandabschnitt (2013) und dem zweiten Wandabschnitt (2014) angeordnet ist, und
die Tastenhalterung i (211) einen Einsetzabschnitt (2111) einschließt, der auf einer Seite der ringförmigen Erhebung (2110) angeordnet ist, die von dem offenen Ende (2011) abgewandt ist, wobei der Einsetzabschnitt (2111) in den zweiten Wandabschnitt (2014) eingesetzt ist.

6. Kopfhörer (100) nach Anspruch 5, wobei ein äußerer Umfang des Einsetzabschnitts (2111) mit einem inneren Umfang des zweiten Wandabschnitts (2014) zusammenpasst.

7. Kopfhörer (100) nach Anspruch 1, wobei
die Gehäusebaugruppe (20) weiter eine elastische Deckschicht (203) einschließt, die an einer äußeren Fläche des ersten Gehäuses (201) abgedeckt ist,
auf einer Seite, auf der sich das offene Ende i (2011) befindet, das erste Gehäuse I (201) einen freiliegenden Abschnitt (201 a) aufweist, der nicht von der elastischen Deckschicht (203) abgedeckt ist, und der freiliegende Abschnitt (201 a) in das zweite Gehäuse (202) eingesetzt ist, und
das zweite Gehäuse (202) in einer Einsetzrichtung des freiliegenden Abschnitts (201 a) relativ zu dem zweiten Gehäuse (202) an der elastischen Deckschicht (203) anliegt.

8. Kopfhörer (100) nach Anspruch 7, wobei eine Seite der Tastenanordnung (21), die von dem Unterbringungshohlraum (2010) abgewandt ist, von der elastischen Deckschicht (203) beabstandet ist.

9. Kopfhörer (100) nach Anspruch 7, wobei der freiliegende Abschnitt (201 a) mit dem zweiten Gehäuse (202) zusammenwirkt, um einen Klebespalt (2003) zum Verbinden des Klebeschlitzes (210) zu bilden.

10. Kopfhörer (100) nach Anspruch 1, wobei eine Tiefe mindestens eines Abschnitts des Klebeschlitzes (210) in einer Einsetzrichtung der Tastenanordnung (21) relativ zu dem Unterbringungshohlraum (2010) größer oder gleich 0,2 mm ist.

11. Kopfhörer (100) nach Anspruch 10, wobei eine Breite mindestens eines Abschnitts des Klebeschlitzes (210) in einer vertikalen Richtung der Einsetzrichtung der Tastenanordnung (21) relativ zu dem Unterbringungshohlraum (2010) größer oder gleich 0,4 mm ist.

12. Kopfhörer (100) nach Anspruch 1, wobei
das erste Gehäuse (201) weiter mit einem Aufnahmeschlitz (2004) versehen ist, der mit dem Unterbringungshohlraum (2010) in strömungstechnischer Kommunikation steht,
der Kopfhörer (100) weiter eine Schnittstellenbaugruppe (22) einschließt, die in den Aufnahmeschlitz (2004) eingesetzt ist, und
das zweite Gehäuse (202) so ausgestaltet ist, dass es die Schnittstellenbaugruppe (22) teilweise abdeckt.

13. Kopfhörer (100) nach Anspruch 12, der weiter einen staubdichten Stecker (23) einschließt, wobei
der staubdichte Stecker (23) einen Steckerkörper (231) und einen Befestigungsabschnitt (232) einschließt, der Befestigungsabschnitt (232) an dem ersten Gehäuse I (201) zwischen der Tastenbaugruppe und der Schnittstellenbaugruppe (22) durch das zweite Gehäuse (202) angeordnet ist, und
der Steckerkörper (231) mit dem Befestigungsabschnitt (232) verbunden und so ausgestaltet ist, dass er die Schnittstellenbaugruppe (22) selektiv abdeckt.

14. Kopfhörer (100) nach Anspruch 13, wobei der staubdichte Stecker (23) eine Verformungsfähigkeit aufweist.

15. Kopfhörer (100) nach Anspruch 13, wobei der Befestigungsabschnitt (232) eine Nut (2321) aufweist, das zweite Gehäuse (202) mit einem Durchgangsloch (202a) versehen ist, der Befestigungsabschnitt (232) durch das Durchgangsloch (202a) in das zweite Gehäuse (202) eingesetzt ist und eine Lochwand des Durchgangslochs (202a) in die Nut eingerastet ist.

## Revendications

1. Casque audio (100), comprenant :
un ensemble de logement (20) incluant un premier logement (201) et un second logement (202), le premier logement (201) étant doté d'une cavité d'hébergement (2010) avec au moins une extrémité ouverte (2011) ;
et un ensemble de clé (21) ;
**caractérisé en ce que** :
l'ensemble de clé (21) est au moins partiellement inséré dans la cavité d'hébergement (2010) par l'extrémité ouverte (2011), l'ensemble de clé (21) coopérant avec le premier logement (201) pour former une fente de colle (210) visible de l'extérieur du premier logement (201) à travers l'extrémité ouverte (2011), dans lequel le second logement (202) est agencé sur l'extrémité ouverte (2011) du premier logement (201) et recouvre la fente de colle (210).

2. Casque audio (100) selon la revendication 1, dans lequel
l'ensemble de clé (21) inclut un support de clé (211) avec une protubérance annulaire (2110) disposée sur une surface de paroi extérieure,
une plateforme de support annulaire (2012) est disposée sur une surface de paroi intérieure du premier logement (201), la protubérance annulaire (2110) est supportée sur la plateforme de support annulaire (2012), et la protubérance annulaire (2110) s'enfonce d'une distance spécifique par rapport à l'extrémité ouverte (2011), et
d'un côté de la protubérance annulaire (2110) faisant face à l'extrémité ouverte (2011), la surface de paroi extérieure du support de clé (211) et la surface de paroi intérieure du premier logement (201) coopèrent l'une avec l'autre pour former la fente de colle (210).

3. Casque audio (100) selon la revendication 2, dans lequel
une surface d'extrémité extérieure du support de clé (211) qui est éloignée de la cavité d'hébergement (2010) fait saillie de l'extrémité ouverte (2011),
l'ensemble de clé (21) inclut un organe de pression élastique (212) prévu sur la surface d'extrémité extérieure,
le second logement (202) est doté d'un trou de clé (2020), et
l'organe de pression élastique (212) est exposé à travers le trou de clé (2020).

4. Casque audio (100) selon la revendication 3, dans lequel
l'ensemble de clé (21) inclut un organe de pression extérieur (213), une partie de l'organe de pression extérieur (213) est insérée dans le trou de clé (2020), et une autre partie de l'organe de pression extérieur (213) est disposée en saillie d'une surface extérieure du second logement (202), et l'organe de pression extérieur (213) bute contre l'organe de pression élastique (212).

5. Casque audio (100) selon la revendication 2, dans lequel
dans une direction d'insertion de l'ensemble de clé (21) par rapport à la cavité d'hébergement (2010), le premier logement (201) inclut une première partie de paroi (2013) et une seconde partie de paroi (2014) reliées entre elles, la seconde partie de paroi (2014) étant disposée d'un côté de la première partie de paroi (2013) à l'écart de l'extrémité ouverte (2011),
la plateforme de support annulaire i (2012) est disposée à une jonction entre la première partie de paroi (2013) et la seconde partie de paroi (2014), et
le support de clé i (211) inclut une partie d'insertion (2111) disposée d'un côté de la protubérance annulaire (2110) à l'écart de l'extrémité ouverte (2011), la partie d'insertion (2111) étant insérée dans la seconde partie de paroi (2014).

6. Casque audio (100) selon la revendication 5, dans lequel une circonférence extérieure de la partie d'insertion (2111) correspond à une circonférence intérieure de la seconde partie de paroi (2014).

7. Casque audio (100) selon la revendication 1, dans lequel
l'ensemble de logement (20) inclut en outre une couche de revêtement élastique (203) recouvrant une surface extérieure du premier logement (201),
du côté où se trouve l'extrémité ouverte i (2011), le premier logement I (201) présente une partie exposée (201 a) qui n'est pas recouverte par la couche de revêtement élastique (203), et la partie exposée (201 a) est insérée dans le second logement (202), et
le second logement (202) bute contre la couche de revêtement élastique (203) dans une direction d'insertion de la partie exposée (201 a) par rapport au second logement (202).

8. Casque audio (100) selon la revendication 7, dans lequel un côté de l'ensemble de clé (21) qui est à l'écart de la cavité d'hébergement (2010) est espacé de la couche de revêtement élastique (203).

9. Casque audio (100) selon la revendication 7, dans lequel la partie exposée (201 a) coopère avec le second logement (202) pour former un espace de colle (2003) pour se relier à la fente de colle (210).

10. Casque audio (100) selon la revendication 1, dans lequel une profondeur d'au moins une partie de la fente de colle (210) est supérieure ou égale à 0,2 mm dans une direction d'insertion de l'ensemble de clé (21) par rapport à la cavité d'hébergement (2010).

11. Casque audio (100) selon la revendication 10, dans lequel une largeur d'au moins une partie de la fente de colle (210) est supérieure ou égale à 0,4 mm dans une direction verticale de la direction d'insertion de l'ensemble de clé (21) par rapport à la cavité d'hébergement (2010).

12. Casque audio (100) selon la revendication 1, dans lequel
le premier logement (201) est en outre doté d'une fente de réception (2004) en communication de flux avec la cavité d'hébergement (2010),
le casque audio (100) inclut en outre un ensemble d'interface (22) inséré dans la fente de réception (2004), et
le second logement (202) est configuré pour recouvrir partiellement l'ensemble d'interface (22).

13. Casque audio (100) selon la revendication 12, incluant en outre une prise anti-poussière (23), dans lequel
la prise anti-poussière (23) inclut un corps de prise (231) et une partie de fixation (232), la partie de fixation (232) est disposée sur le premier logement I (201) entre l'ensemble de clé et l'ensemble d'interface (22) à travers le second logement (202), et
le corps de prise (231) est relié à la partie de fixation (232) et configuré pour couvrir sélectivement l'ensemble d'interface (22).

14. Casque audio (100) selon la revendication 13, dans lequel la prise anti-poussière (23) présente une capacité de déformation.

15. Casque audio (100) selon la revendication 13, dans lequel la partie de fixation (232) présente une rainure (2321), le second logement (202) est doté d'un trou traversant (202a), la partie de fixation (232) est insérée dans le second logement (202) à travers le trou traversant (202a), et une paroi de trou du trou traversant (202a) est encliquetée dans la rainure.
